(19) Europäisches Patentamt / European Patent Office / Office européen des brevets

(11) **EP 4 772 580 A1**

(12) **EUROPEAN PATENT APPLICATION**
published in accordance with Art. 153(4) EPC


(43) Date of publication:
**08.07.2026 Bulletin 2026/28**

(21) Application number: **24859177.8**

(22) Date of filing: **09.07.2024**

(51) International Patent Classification (IPC):
***C08L 79/04*** *(2006.01)* ***C08G 73/06*** *(2006.01)*
***C08K 5/20*** *(2006.01)* ***C08K 5/156*** *(2006.01)*
***G03F 7/031*** *(2006.01)* ***G03F 7/037*** *(2006.01)*
***H10K 59/122*** *(2023.01)* ***H10K 85/10*** *(2023.01)*

(52) Cooperative Patent Classification (CPC):
**C08G 73/06; C08K 5/156; C08K 5/20; C08L 79/04; G03F 7/031; G03F 7/037; H10K 59/122; H10K 85/10**

(86) International application number:
**PCT/JP2024/024716**

(87) International publication number:
**WO 2025/047132 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.08.2023 JP 2023138702**



(71) Applicant: **Toray Industries, Inc.**
**Tokyo 103-8666 (JP)**

(72) Inventors:
- **SAEKI Akinori**
  **Otsu-shi, Shiga 520-8558 (JP)**
- **KANEKI Takayuki**
  **Otsu-shi, Shiga 520-8558 (JP)**

(74) Representative: **Kador & Partner Part mbB**
**Corneliusstraße 15**
**80469 München (DE)**


(54) **RESIN COMPOSITION, CURED FILM, ELECTRONIC COMPONENT, AND ORGANIC EL DISPLAY DEVICE**


(57) A resin composition including: a component (A) being one or more resins selected from the group consisting of a polyimide resin (A1), a polybenzoxazole resin (A2), and a copolymer resin (A3) of a structural unit of the polyimide resin and a structural unit of the polybenzoxazole resin; and a component (B) being levoglucosenone and/or dihydrolevoglucosenone. Provided are a resin composition capable of affording a cured film having good chemical resistance, adhesion to metals, flatness, and breaking elongation, an electronic component and an organic EL display device each including the cured film of the resin composition.


【Fig. 1】

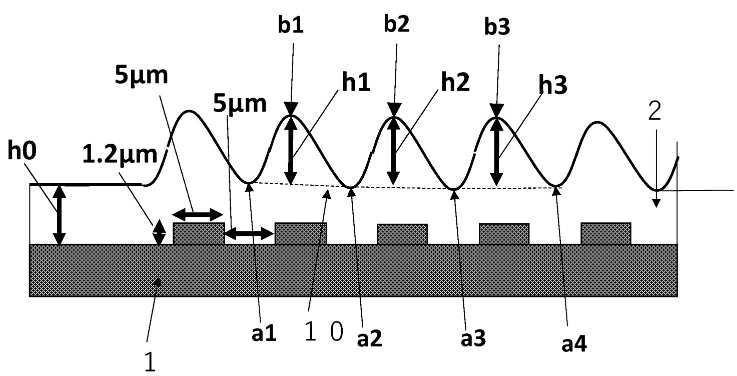


EP 4 772 580 A1

## Description

### TECHNICAL FIELD

The present invention relates to a resin composition, a cured film, an electronic component, and an organic EL display device.

### BACKGROUND ART

Conventionally, polyimide resins and polybenzoxazole resins, which are excellent in heat resistance, electrical insulation properties, mechanical characteristics, and the like, have been widely used in a surface protective film and an interlayer insulating film of a semiconductor element, a pixel defining layer and a planarization layer of an organic electroluminescent (hereinafter, organic EL) display device.

In the case of making a coating film of a polyimide resin or a polybenzoxazole resin undergo thermal dehydrative cyclization to obtain a thin film excellent in heat resistance and mechanical characteristics, it is usually required to conduct high temperature calcination at around 350°C. The operation conducted in making a coating film of a polyimide resin or a polybenzoxazole resin undergo thermal dehydrative cyclization to obtain a thin film excellent in heat resistance and mechanical characteristics may be referred to as calcination (curing), and the change of the coating film may be referred to as cure. However, from the viewpoint that a memory device used in recent years, a mold resin used in production of a semiconductor package, and the like are weak against a high-temperature process, and from the viewpoint of semiconductor package reliability, a polyimide-based resin, a polybenzoxazole-based resin, and a polyamideimide-based resin that can be cured by calcination at 250°C or less and have higher mechanical characteristics, chemical resistance, and adhesion are required for a surface protective film and an interlayer insulating film.

Furthermore, in organic EL display devices and semiconductor devices, densification of pixels and wirings has progressed, and materials suitable for fine processing of patterns and planarization of an object surface having an uneven surface are demanded.

To solve the above problems, for example, for the purpose of improving breaking elongation and resistant chemical, a resin composition including a polyimide or polybenzoxazole resin having a specific structure, a thermal acid generator, and an antioxidant (see, for example, Patent Document 1) has been proposed. In addition, for the purpose of improving flatness and folding strength, a photosensitive resin composition including a polyimide or polybenzoxazole resin and a phenol resin having a specific structure (see, for example, Patent Document 2) has been proposed.

### PRIOR ART DOCUMENT

### PATENT DOCUMENTS

Patent Document 1: WO 2017/188153 A
Patent Document 2: JP 2022-34533 A

### SUMMARY OF THE INVENTION

### PROBLEMS TO BE SOLVED BY THE INVENTION

When the present inventors evaluated the flatness using the resin composition described in Patent Document 1, there was a problem that the flatness required for the planarization layer of an organic EL display device cannot be obtained. In addition, when the present inventors evaluated the breaking elongation and the adhesion to a metal material using the photosensitive resin composition described in Patent Document 2, there were a problem that the resulting film was slightly brittle and a sufficient breaking elongation could not be obtained, and a problem that the adhesion to a metal material was low. As described above, a resin composition that satisfies all of the breaking elongation, the chemical resistance, the flatness, and the adhesion is not actually known.

Thus, an object of the present invention is to provide a resin composition capable of affording a cured film having good chemical resistance, adhesion to metals, flatness, and breaking elongation, an electronic component and an organic EL display device each including a cured film of the resin composition.

SOLUTIONS TO THE PROBLEMS

In order to solve the problems as described above, the present invention has the constitution as described below.

[1] A resin composition including: a component (A) being one or more resins selected from the group consisting of a polyimide resin (A1), a polybenzoxazole resin (A2), and a copolymer resin (A3) of a structural unit of a polyimide resin and a structural unit of a polybenzoxazole resin; and a component (B) being levoglucosenone and/or dihydrolevoglucosenone.

[2] The resin composition according to [1], further including a component (D) being a compound having a hydroxyl group and having a boiling point at atmospheric pressure of 100°C or more and 200°C or less.

[3] The resin composition according to [2], wherein a ratio X/Z is 0.01 or more and 10 or less where a mass of the component (B) contained in the resin composition is denoted by X and a mass of the component (D) contained in the resin composition is denoted by Z.

[4] The resin composition according to any one of [1] to [3], further including a component (C) being a compound represented by formula (1) and/or a compound represented by formula (2).

[Chemical Formula 1]

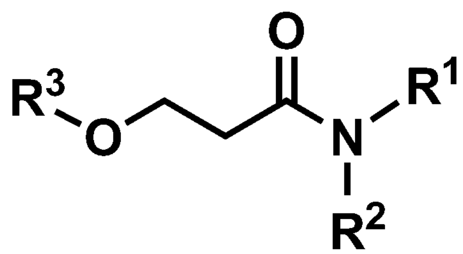

(1)

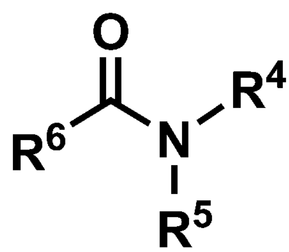

(2)

In the formula (1), $R^1$, $R^2$ and $R^3$ are each independently an alkyl group having 1 to 6 carbon atoms. In the formula (2), $R^4$ and $R^5$ are each independently an alkyl group having 1 to 6 carbon atoms. $R^6$ is a hydrogen atom or an alkyl group having 1 to 6 carbon atoms.

[5] The resin composition according to [4], wherein a ratio X/Y is 1 or more and 1,000 or less where a mass of the component (B) contained in the resin composition is denoted by X and a mass of the component (C) contained in the resin composition is denoted by Y.

[6] The resin composition according to any one of [1] to [5], further including a component (E) being a photosensitive agent.

[7] The resin composition according to [6], wherein the component (E) includes a component (E1) being a photo initiator and/or a component (E2) being a photoacid generator.

[8] The resin composition according to [7], wherein the component (E1) includes a component (E1-1) being an oxime ester photoinitiator and/or a component (E1-2) being a titanocene photoinitiator.

[9] The resin composition according to [7] or [8], further including a component (F) being a radical polymerizable compound.

[10] The resin composition according to any one of [1] to [9], wherein the component (A) includes a polyimide resin (A1) and/or a copolymer resin (A3) of a structural unit of a polyimide resin and a structural unit of a polybenzoxazole resin, and the component (A) contains a structural unit represented by formula (3).

[Chemical Formula 2]

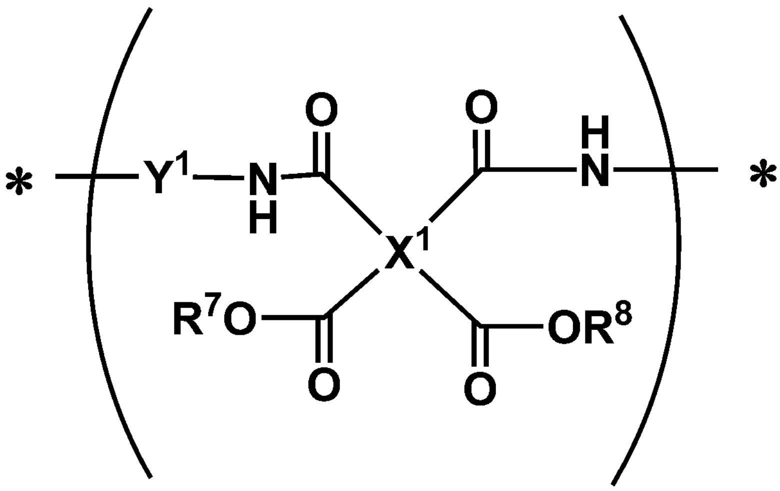

(3)

In the formula (3), $X^1$ represents a tetravalent organic group having 2 to 40 carbon atoms and having any structure among an aliphatic structure having 2 to 20 carbon atoms, an alicyclic structure having 4 to 20 carbon atoms, and an aromatic structure having 6 to 40 carbon atoms. $Y^1$ represents a divalent organic group having 2 to 40 carbon atoms and having any structure among an aliphatic structure having 2 to 20 carbon atoms, an alicyclic structure having 4 to 20 carbon atoms, and an aromatic structure having 6 to 40 carbon atoms. $R^7$ and $R^8$ each independently represent a hydrogen atom, an alkyl group having 1 to 20 carbon atoms, or a monovalent organic group having an ethylenically unsaturated double bond. Each * represents a bonding site.

[11] The resin composition according to [10], wherein $Y^1$ in the formula (3) is a divalent organic group represented by the formula (4) or the formula (5).

[Chemical Formula 3]

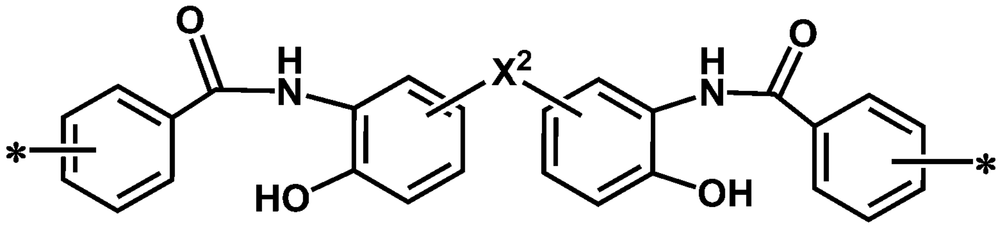

(4)

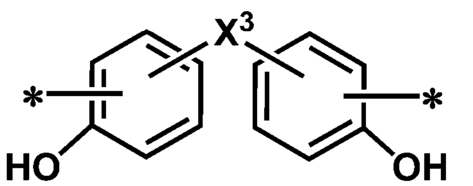

(5)

In the formulas (4) and (5), $X^2$ and $X^3$ each independently represent a direct bond, $-SO_2-$, -O-, or a divalent organic group having 1 to 20 carbon atoms. Each * represents a bonding point bonded to an amide structure, an imide structure, an amic acid ester structure, or an amic acid structure.

[12] The resin composition according to [11], wherein $X^2$ and $X^3$ are each independently a divalent organic group having 1 to 20 carbon atoms and containing no fluorine atom.

[13] A cured film including a cured product of the resin composition according to any one of [1] to [12].

[14] An electronic component including the cured film according to [13].

[15] An organic EL display device including the cured film according to [13].

EFFECTS OF THE INVENTION

According to the present invention, it is possible to obtain a resin composition capable of affording a cured film having good flatness and also having good chemical resistance, adhesion to metals, and breaking elongation, and an electronic component and an organic EL display device each including a cured film of the resin composition.

BRIEF DESCRIPTION OF THE DRAWINGS

Fig. 1 is a sectional view of a flatness evaluation sample.
Fig. 2 is a schematic diagram illustrating a method of manufacturing an organic EL display device including a pixel defining layer in Examples.

EMBODIMENTS OF THE INVENTION

Hereinafter, the present invention will be described in detail.
In the present description, a numerical range represented using "to" means a range including numerical values located before and after "to" as the lower limit and the upper limit.
The resin composition of the present invention includes a component (A) being one or more resins selected from the group consisting of a polyimide resin (A1), a polybenzoxazole resin (A2), and a copolymer resin (A3) of a structural unit of a polyimide resin and a structural unit of a polybenzoxazole resin. The inclusion of the component (A) makes it possible to obtain a cured film that outgasses in a small amount at high temperature and is excellent in film properties such as chemical resistance.
The polyimide resin (A1) and the copolymer resin (A3) of a structural unit of a polyimide resin and a structural unit of a polybenzoxazole resin contained in the resin composition of the present invention also include those intended to form an imide ring after the curing operation, and thus also include those having a structure before ring-closing to the imide ring, that is, a structure of an amide acid (or amic acid) or an amic acid ester.
The polybenzoxazole resin (A2) and the copolymer resin (A3) of a structural unit of a polyimide resin and a structural unit of a polybenzoxazole resin contained in the resin composition of the present invention also include those intended to form a benzoxazole ring after the curing operation, and thus also include those having a structure before ring-closing to the oxazole ring, that is, a structure of a hydroxyamide.
Examples of the component (A) include a resin soluble in an organic developer such as a ketone-based solvent, an ester-based solvent, or an amide-based solvent, and an alkali-soluble resin soluble in an alkaline developer.
Among them, from the viewpoint of reducing the environmental load, it is preferable that the component (A) is an alkali-soluble resin, and the resin composition can be developed using an alkaline developer. The alkali-soluble resin referred to herein means a resin that exhibits a dissolution rate of 50 nm/minute or more determined from a reduction in film thickness in the case of applying a solution of the resin dissolved in $\gamma$-butyrolactone onto a silicon wafer, forming a prebaked film of 10 $\mu$m $\pm$ 0.5 $\mu$m in film thickness by pre-baking for 4 minutes at 120°C, immersing the prebaked film in a 2.38 mass% aqueous tetramethylammonium hydroxide solution at 23 $\pm$ 1°C for 1 minute, and then subjecting the film to a rinse treatment with deionized water. The alkali dissolution rate of the component (A) is preferably 100 nm/min or more from the viewpoint of reduction of development residues, and is preferably 15,000 nm/min or less from the viewpoint of improving the linearity of a resulting pattern.
When the total amount of the resin contained in the resin composition of the present invention is 100 mass%, the resin composition preferably contains the component (A) being one or more resins selected from the group consisting of the polyimide resin (A1), the polybenzoxazole resin (A2), and the copolymer resin (A3), in a total amount of 50 mass% or more.
The polyimide resin (A1) and the copolymer resin (A3) preferably have an acid dianhydride residue and a diamine residue. The acid dianhydride residue as used herein refers to a residue obtained by removing two acid anhydride groups from an acid dianhydride compound, and the diamine residue refers to a residue obtained by removing two amino groups from a diamine compound.
The polyimide resin (A1) and the copolymer resin (A3) may have an acid dianhydride residue derived from the following acid dianhydrides:
Examples of the acid dianhydride residue include residues of alicyclic tetracarboxylic dianhydrides such as 1,2-dimethyl-1,2,3,4-cyclobutanetetracarboxylic dianhydride, 1,3,3a,4,5,9b-hexahydro-5(tetrahydro-2,5-dioxo-3-furanyl) naphtho[1,2-c]furan-1,3-dione (hereinafter TDA-100), 1,2,3,4-tetramethyl-1,2,3,4-cyclobutanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, bicyclo[2.2.2]oct-7-ene-2,3,5,6-tetracarboxylic

dianhydride, 2,3,4,5-tetrahydrofurantetracarboxylic dianhydride, and 3,5,6-tricarboxy-2-norbornaneacetic dianhydride; residues of aromatic tetracarboxylic acid dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,2,5,6-naphthalenetetracarboxylic dianhydride, 2,3,6,7-naphthalenetetracarboxylic dianhydride, 2,3,5,6-pyridinetetracarboxylic dianhydride, and 3,4,9,10-perylenetetracarboxylic dianhydride; and residues of aromatic dianhydrides such as bis(3,4-dicarboxyphenyl)sulfone dianhydride, 4,4'-oxydiphthalic anhydride (hereinafter ODPA), 3,4'-oxydiphthalic anhydride, bis(3,4-dicarboxyphenyl) ether dianhydride, 2,2-bis(3,4-dicarboxyphenyl)hexafluoropropane dianhydride, 2,2-bis(4-(3,4-dicarboxyphenoxy)phenyl)propane dianhydride, 2,2-bis(3-(3,4-dicarboxyphenoxy)phenyl)propane dianhydride, 2,2-bis(4-(3,4-dicarboxyphenoxy)phenyl)hexafluoropropane dianhydride, 2,2-bis(3-(3,4-dicarboxyphenoxy)phenyl)hexafluoropropane dianhydride, compounds obtained by substituting aromatic rings of these compounds with an alkyl group or a halogen atom, and acid dianhydrides having an amide group. Two or more of these can be contained in combination.

The component (A) being one or more resins selected from the group consisting of the polyimide resin (A1), the polybenzoxazole resin (A2), and the copolymer resin (A3) preferably contains a residue of a diamine represented by formula (16) and/or a residue of a diamine represented by formula (17).

[Chemical Formula 4]

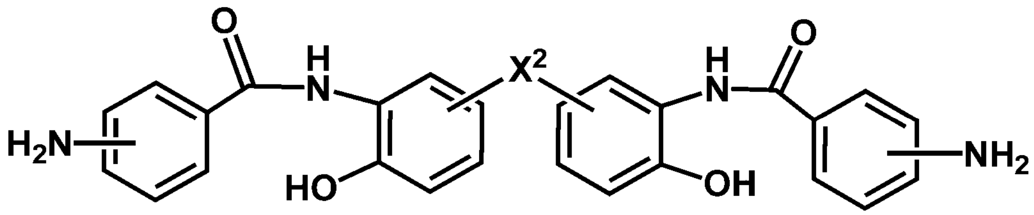

(16)

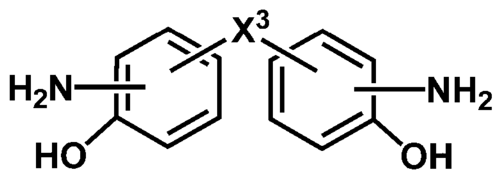

(17)

In the formulas (16) and (17), $X^2$ and $X^3$ each independently represent a direct bond, $-SO_2-$, -O-, or a divalent organic group having 1 to 20 carbon atoms. * indicates a bonding point bonded to a nitrogen atom.

Since the structures represented by the formulas (16) and (17) have a phenolic hydroxyl group, solubility in an alkaline developer can be imparted, and development residues can be reduced. The fact that $X^2$ and $X^3$ are each independently any one selected from the group consisting of $-C(CF_3)_2-$, $-CH(CF_3)-$, and $-C(CH_3)_2-$ is preferable because intermolecular packing is suppressed, and solvent solubility can be improved. In addition, the fact that $X^2$ and $X^3$ are each independently a divalent organic group having 1 to 20 carbon atoms and containing no fluorine atom is preferable because metal adhesion after a pressure cooker test (PCT) treatment can be improved. Among the divalent organic groups having 1 to 20 carbon atoms and containing no fluorine atom, it is more preferable that $X^2$ and $X^3$ are each independently a divalent organic group represented by formula (18) or formula (19).

[Chemical Formula 5]

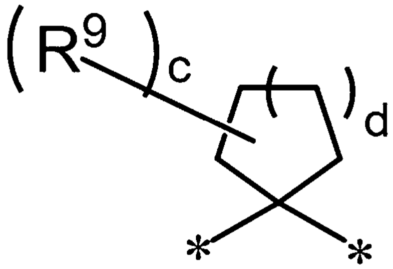 (18) 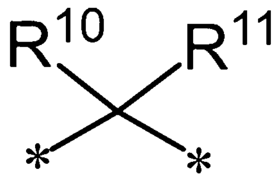 (19)

In the formulas (18) and (19), $R^9$ independently at each occurrence represents an alkyl group having 1 to 4 carbon atoms, c represents an integer of 1 to 3, d represents 1 or 2, $R^{10}$ and $R^{11}$ each independently represent a hydrocarbon group having 1 to 10 carbon atoms or a hydrogen atom, and * represents a bonding point bonded to an aromatic ring. When there is a plurality of $R^9$, they may have the same structure or different structures. In addition, $R^{10}$ and $R^{11}$ do not have the same structure.

The fact that $X^2$ and $X^3$ are each independently a divalent organic group represented by the formula (18) or (19) is preferable because metal adhesion after PCT treatment can be improved, and solvent solubility can be improved.

In particular, it is preferable that in the formula (18), the total number of the carbon atoms of $R^9$ is 1 or more and 5 or less, and in the formula (19), the total number of the carbon atoms of $R^{10}$ and the carbon atoms of $R^{11}$ is 3 or more and 10 or less. The expression "in the formula (18), the total number of the carbon atoms of $R^9$ is 1 or more and 5 or less" referred to here means that, for example, in a case where there is a plurality of $R^9$ in the formula (18), the sum of the number of the carbon atoms of each of the plurality of $R^9$ is 1 or more and 5 or less. The expression "in the formula (19), the total number of the carbon atoms of $R^{10}$ and the carbon atoms of $R^{11}$ is 3 or more and 10 or less" referred to here means that the sum of the counted number of the carbon atoms of $R^{10}$ and the counted number of the carbon atoms of $R^{11}$ is 3 or more and 10 or less. The fact that the numbers of the carbon atoms of $R^9$, $R^{10}$, and $R^{11}$ are within the above ranges is preferable because a photosensitive resin composition having good metal adhesion after PCT treatment and solvent solubility can be obtained without deteriorating development residues and sensitivity.

Examples of the divalent organic group represented by the formula (18) or (19) include, but are not limited to, the structures shown below.

[Chemical Formula 6]

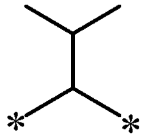 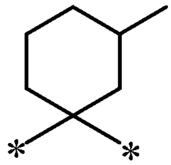 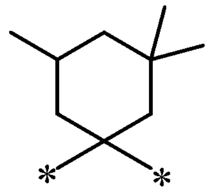

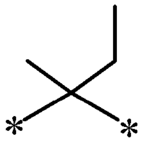 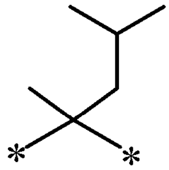 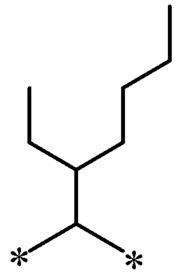

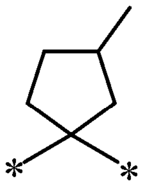 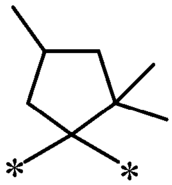 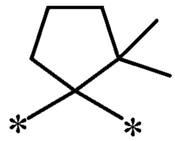

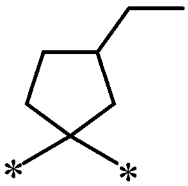

In the above structures, each * represents a bonding point bonded to an aromatic ring.

Where the total amount of all diamine residues contained in the polyimide resin (A1), the polybenzoxazole resin (A2), and the copolymer resin (A3) is 100 mol%, the total content of the residue of the diamine represented by the formula (4) and the residue of the diamine represented by the formula (5) is preferably 10 to 100 mol%, more preferably 30 to 100 mol%, and still more preferably 50 to 100 mol%.

Examples of the diamine residue represented by the formula (4) or the formula (5) include residues of 2,2-bis[3-(3-aminobenzamido)-4-hydroxyphenyl]hexafluoropropane (hereinafter HA), 2,2-bis[3-(3-aminobenzamido)-4-hydroxyphenyl]-1,1,1-trifluoroethane, 2,2-bis[3-(3-aminobenzamido)-4-hydroxyphenyl]propane, 9,9-bis[3-(3-aminobenzamido)-4-hydroxyphenyl]fluorene, 2,2-bis(3-amino-4-hydroxyphenyl)hexafluoropropane (hereinafter BAHF), bis(3-amino-4-hydroxyphenyl) sulfone, 9,9-bis(3-amino-4-hydroxyphenyl)fluorene, 2,2-bis(3-amino-4-hydroxyphenyl)propane (hereinafter BAP), 1,1,1-trifluoro-2,2-bis(3-amino-4-hydroxyphenyl)ethane (hereinafter BIS-AP-EF), and diamines of formula (20) to formula (39). Among them, from the viewpoint of solubility in an alkaline developer, it is preferable to contain a residue of any diamine selected from the group consisting of BAHF, BAP, BIS-AP-EF, HA, 2,2-bis[3-(3-aminobenzamido)-4-hydroxyphenyl]-1,1,1-trifluoroethane, 2,2-bis[3-(3-aminobenzamido)-4-hydroxyphenyl]propane, and the formula (20) to the formula (39), and it is more preferable to contain a residue of any diamine selected from the group consisting of the formula (20) to the formula (39) from the viewpoint that the metal adhesion after PCT treatment can be improved and, in addition, the solvent solubility can be improved.

[Chemical Formula 7]

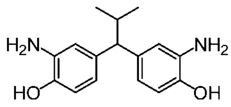 (20) 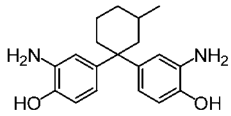 (21) 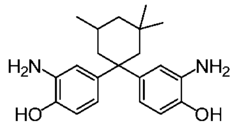 (22)

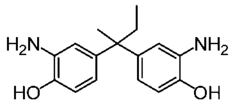 (23) 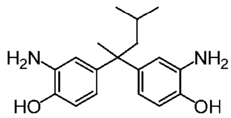 (24) 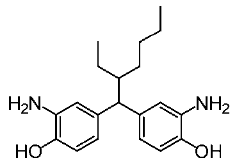 (25)

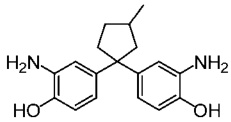 (26) 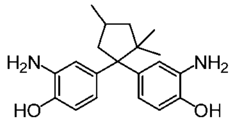 (27) 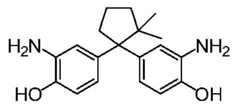 (28)

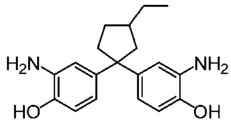 (29)

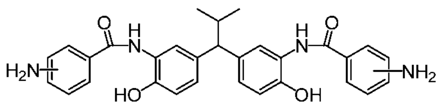 (30) 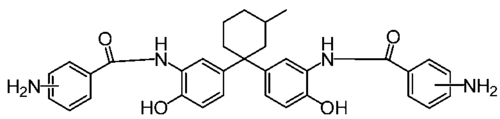 (31)

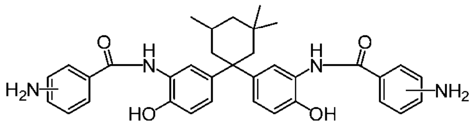 (32) 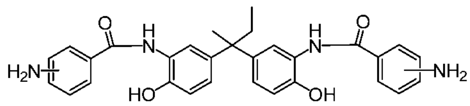 (33)

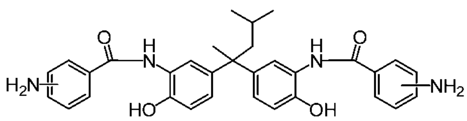 (34) 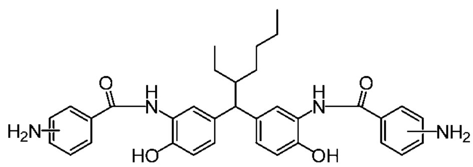 (35)

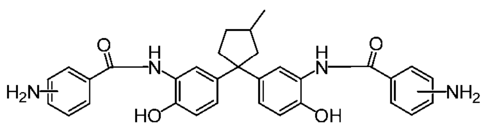 (36) 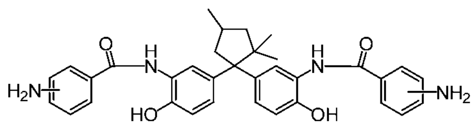 (37)

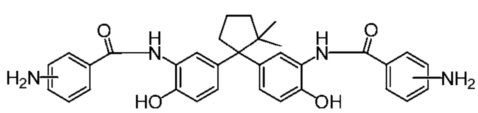 (38) 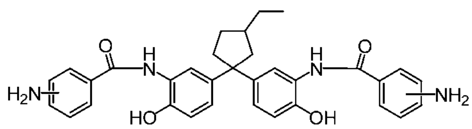 (39)

The polyimide resin (A1), the polybenzoxazole resin (A2), and the copolymer resin (A3) may have another diamine residue in addition to the above-described diamine residue.

Examples of the other diamine residue include an aliphatic diamine residue and an aromatic diamine residue. The aliphatic diamine residue means a residue of a diamine having no aromatic ring. Examples of the aliphatic diamine residue include residues of aliphatic alkylenediamines containing an alkylene group, or an alkylene ether group such as a polyethylene ether group, a polyoxypropylene group, or a tetramethylene ether group, alicyclic diamines, and aliphatic diamines having a siloxane structure.

Examples of the aliphatic alkylenediamine residue include residues of polymethylenediamines such as tetramethylenediamine, hexamethylenediamine, octamethylenediamine, decamethylenediamine, dodecamethylenediamine, 7-ethylhexadecanediamine, 7,12-dimethyloctadecanediamine, 8,13-dimethyloctadecanediamine, 8-methylnonadecanediamine, 9-methylnonadecanediamine, 7,12-dimethyloctadecanediamine-7,11-ene, 8,13-dimethyloctadecanediamine-8,12-ene, and Diamine H20 (trade name, manufactured by Okamura Oil Mill, Ltd.); diamines containing a polyethylene ether group such as JEFFAMINE KH-511, JEFFAMINE ED-600, JEFFAMINE ED-900, JEFFAMINE ED-2003, JEFFAMINE EDR-148, and JEFFAMINE EDR-176; polyoxypropylenediamines such as D-200, D-400, D-2000, D-4000, RP-409, and RP-2009; diamines containing a tetramethylene ether group such as RT-1000 and HT-1100; amino group-containing alkylene ether diamines such as HT-1000 and HE-1000 (trade names, manufactured by HUNTSMAN Corporation); and dimer diamines such as "Versamine" (registered trademark) 551, "Versamine" (registered trademark) 552 (manufactured by BASF), "Priamine" (registered trademark) 1073, "Priamine" (registered trademark) 1074, and "Priamine" (registered trademark) 1075 (manufactured by Cargill).

Examples of the alicyclic diamine residue include residues of cyclohexyldiamine, methylenebis(cyclohexylamine), norbornanediamine, and PRO-NBDA (trade name, manufactured by Mitsui Fine Chemicals, Inc.).

Examples of the aliphatic diamine residue having a siloxane structure include residues of 1,3-bis(3-aminopropyl) tetramethyldisiloxane (hereinafter SiDA) and bis(p-aminophenyl)octamethylpentasiloxane. When an aliphatic group having a siloxane structure is copolymerized in a range in which heat resistance is not deteriorated, adhesion property with a substrate can be improved.

Examples of other aromatic diamine residues include residue of hydroxyl group-containing diamines such as 1,4-bis(4-aminophenoxy)benzene, 1,3-bis(3-aminophenoxy)benzene, 1,3-bis(4-aminophenoxy)benzene, bis[4-(4-aminophenoxy)phenyl]sulfone, bis[4-(3-aminophenoxy)phenyl]sulfone, 2,2-bis[4-(4-aminophenoxy)phenyl]propane, 2,2-bis [4-(4-aminophenoxy)phenyl]hexafluoropropane, bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl) ether, bis(3-amino-4-hydroxy)biphenyl, and bis(3-amino-4-hydroxyphenyl)fluorene; residues of sulfonic acid-containing diamines such as 3-sulfonic acid-4,4'-diaminodiphenyl ether; residues of thiol group-containing diamines such as dimercaptophenylenediamine; residues of aromatic diamine such as 3,4'-diaminodiphenyl ether, 4,4'-diaminodiphenyl ether, 3,4'-diaminodiphenylmethane, 4,4'-diaminodiphenylmethane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl) sulfone, bis(3-aminophenoxyphenyl) sulfone, bis(4-aminophenoxy) biphenyl, bis{4-(4-aminophenoxy)phenyl} ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl; and residues of compound obtained by replacing some of hydrogen atoms of these aromatic rings with an alkyl group having 1 to 10 carbon atoms, a fluoroalkyl group, a halogen atom, or the like. These diamine residues can be used as they are, as corresponding diisocyanate compounds, or as corresponding trimethylsilylated diamines. These may be used alone or in combination of two or more.

The polybenzoxazole resin (A2) and the copolymer resin (A3) preferably have a dicarboxylic acid residue and a bisaminophenol residue. The dicarboxylic acid residue as used herein refers to a residue obtained by removing two carboxyl groups from a dicarboxylic acid compound, and the bisaminophenol residue refers to a residue obtained by removing two amino groups and two phenolic hydroxyl groups from a bisaminophenol compound.

Examples of the dicarboxylic acid residue include residues of phthalic acid, terephthalic acid, isophthalic acid, diphenyl ether dicarboxylic acid, bis(carboxyphenyl)hexafluoropropane, biphenyldicarboxylic acid, benzophenone dicarboxylic acid, triphenyldicarboxylic acid, 2,5-furandicarboxylic acid, 2,5-thiophenedicarboxylic acid, 1,4-cyclohexanedicarboxylic acid, 1,3-cyclohexanedicarboxylic acid, 2-fluoroterephthalic acid, 2-methoxyterephthalic acid, and 2-phenoxyterephthalic acid. These compounds may be used singly or two or more of them may be used in combination.

Examples of the bisaminophenol residue include, but are not limited to, residues of 3,3'-diamino-4,4'-dihydroxybiphenyl, 4,4'-diamino-3,3'-dihydroxybiphenyl, 2,2-bis(3-amino-4-hydroxyphenyl)propane (BAP), bis(4-amino-3-hydroxyphenyl)propane, bis(3-amino-4-hydroxyphenyl)sulfone, bis(4-amino-3-hydroxyphenyl)sulfone, 2,2-bis(3-amino-4-hydroxyphenyl)hexafluoropropane (BAHF), 2,2-bis(4-amino-3-hydroxyphenyl)-1,1,1,3,3,3-hexafluoropropane, and 9,9-bis(3-amino-4-hydroxyphenyl) fluorene. These compounds may be used singly or two or more of them may be used in combination.

The ends of the polyimide resin (A1), the polybenzoxazole resin (A2), and the copolymer resin (A3) may be capped with an end-capping agent such as a monoamine, an acid anhydride, a monoacid chloride, a monocarboxylic acid, or a monoactive ester. The dissolution rate of the resin in an alkaline aqueous solution can be easily adjusted to a preferable range by capping an end of the resin with an end-capping agent. Among them, it is preferable to use an end-capping agent having a phenolic hydroxyl group or a crosslinkable group. By using the end-capping agent having a phenolic hydroxyl group, alkali solubility is imparted to the resin, so that the residue can be reduced. In addition, by using

the end-capping agent having a crosslinkable group, a crosslinking reaction proceeds in the step of heat curing, so that a cured film excellent in chemical resistance and breaking elongation can be obtained.

Among examples of the monoamine, examples of a monoamine having a phenolic hydroxyl group include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 4-aminosalicylic acid, 5-aminosalicylic acid, 6-aminosalicylic acid, 3-amino-4,6-dihydroxypyrimidine, 2-aminophenol (hereinafter OAP), 3-aminophenol (hereinafter MAP), and 4-aminophenol (hereinafter PAP). Examples of monoamines having a photocrosslinkable group include 2-ethynylaniline, 3-ethynylaniline, 4-ethynylaniline, 2-aminostyrene, 3-aminostyrene, 4-aminostyrene, and examples of other monoamines include aniline, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 2-aminobenzenesulfonic acid, 3-aminobenzenesulfonic acid, and 4-aminobenzenesulfonic acid. Two or more of them may be used.

Among the acid anhydrides, the monocarboxylic acids, the monoacid chloride compounds, or the monoactive ester compounds, examples of those having a phenolic hydroxyl group include 3-hydroxyphthalic anhydride, 3-carboxyphenol, 4-carboxyphenol, 1-hydroxy-7-carboxynaphthalene, 1-hydroxy-6-carboxynaphthalene, and 1-hydroxy-5-carboxynaphthalene. Examples of those having a photocrosslinkable group include maleic anhydride, 5-norbornene-2,3-dicarboxylic anhydride (hereinafter NA), itaconic anhydride, itaconic acid, maleic acid, acrylic acid, methacrylic acid, 3-phenylacrylic acid, crotonic acid, 1,2,3,6-tetrahydrophthalic anhydride, 3,4,5,6-tetrahydrophthalic anhydride, 7-oxabicyclo[2.2.1]hept-5-ene-2,3-dicarboxylic anhydride, and 3-methyl-4-cyclohexene-1,2-dicarboxylic anhydride. Examples of others include acetic anhydride, succinic anhydride, phthalic anhydride, cyclohexanedicarboxylic anhydride, 3-carboxythiophenol, 4-carboxythiophenol, 1-mercapto-7-carboxynaphthalene, 1-mercapto-6-carboxynaphthalene, 1-mercapto-5-carboxynaphthalene, 3-carboxybenzenesulfonic acid, 4-carboxybenzenesulfonic acid, terephthalic acid, phthalic acid, cyclohexanedicarboxylic acid, 1,5-dicarboxynaphthalene, 1,6-dicarboxynaphthalene, 1,7-dicarboxynaphthalene, 2,6-dicarboxynaphthalene, trimellitic anhydride, and cyclohexane-1,2,4-tricarboxylic acid-1,2-anhydride. As the monocarboxylic acids, monoacid chloride compounds in which carboxyl groups of monocarboxylic acids are transformed into acid chlorides may be used, a monoacid chloride compound in which only one carboxyl group of the dicarboxylic acid is transformed into an acid chloride may be used, or an active ester compound obtained by a reaction between a monoacid chloride compound and N-hydroxybenzotriazole or N-hydroxy-5-norbornene-2,3-dicarboximide may be used. Two or more of them may be used.

A plurality of different terminal groups may be introduced by reacting a plurality of end-capping agents.

When a monoamine is used as the end-capping agent, the introduction rate thereof is preferably 1 mol% or more and 60 mol% or less based on 100 mol% of all amine compounds contained in the polyimide resin (A1), the polybenzoxazole resin (A2), and the copolymer resin (A3). By setting the introduction rate of the monoamine to preferably 1 mol% or more, more preferably 5 mol% or more, the effect of reducing residues after development can be effectively obtained. In addition, by setting the introduction rate of the monoamine to preferably 60 mol% or less, more preferably 50 mol% or less, the molecular weight of the resin can be maintained high, and high chemical resistance and high breaking elongation can be maintained.

When an acid anhydride, a monocarboxylic acid, a monoacid chloride compound, or a monoactive ester compound is used as the end-capping agent, the total introduction rate thereof is preferably 1 part by mol or more and 100 parts by mol or less based on 100 parts by mol of all amine compounds contained in the polyimide resin (A1), the polybenzoxazole resin (A2), and the copolymer resin (A3). By setting the introduction rate to preferably 1 part by mol or more, more preferably 5 parts by mol or more, the effect of reducing residues after development can be effectively obtained. On the other hand, by setting the introduction rate to preferably 100 parts by mol or less, more preferably 90 parts by mol or less, the molecular weight of the resin can be maintained high, and high chemical resistance and high breaking elongation can be maintained.

The all amine compounds herein refers to the total content of the compounds having an amino group such as monoamines, diamines, and triamines.

The polystyrene-equivalent weight average molecular weight (Mw) of the polyimide resin (A1), the polybenzoxazole resin (A2), and the copolymer resin (A3) is preferably 3,000 to 100,000 as determined by gel permeation chromatography (GPC). By setting the Mw to 100,000 or less, more preferably 80,000 or less, and still more preferably 60,000 or less, good solvent solubility and good solubility in a developer can be effectively obtained. By setting the weight average molecular weight to 3,000 or more, more preferably 5,000 or more, and still more preferably 7,000 or more, a high breaking elongation can be effectively obtained. In the present invention, Mw is determined by the method described later.

Examples of the polyimide resin (A1) include a reaction product obtained by reacting a tetracarboxylic acid, a corresponding tetracarboxylic dianhydride, a corresponding tetracarboxylic acid diester dichloride, or the like with a diamine, a corresponding diisocyanate compound, a corresponding trimethylsilylated diamine, or the like. In addition, such reaction products may be dehydratively cyclized by heating or a reaction using an acid or a base. Therefore, in a

preferred embodiment, the polyimide resin (A1) has a tetracarboxylic acid and/or a derivative residue thereof and a diamine and/or a derivative residue thereof.

The polyimide resin (A1) preferably has, for example, one or more selected from the group consisting of a structural unit represented by formula (6), a structural unit represented by formula (7), and a structural unit represented by formula (3).

[Chemical Formula 8]

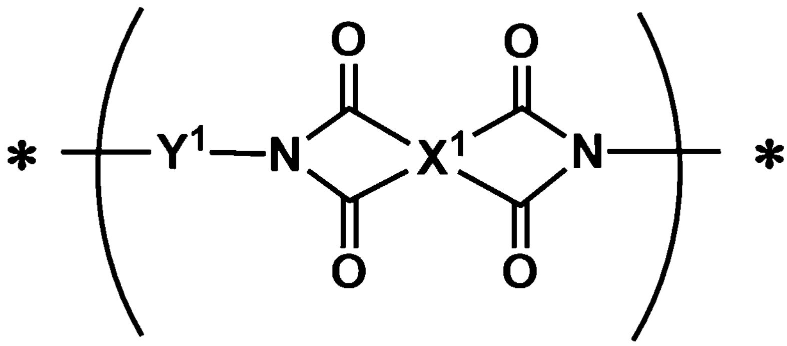
(6)

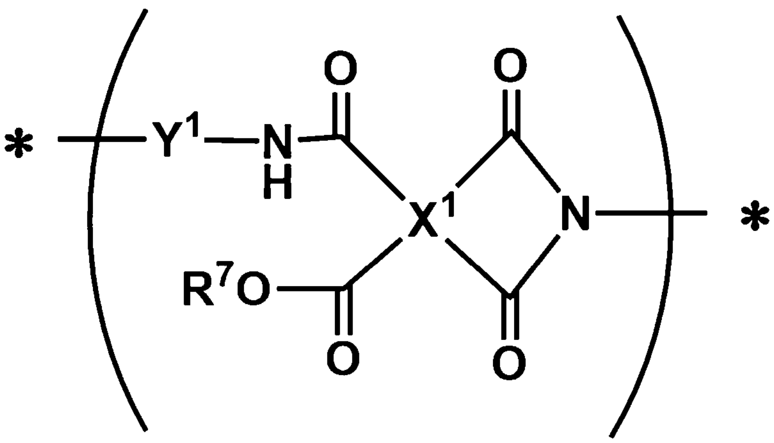
(7)

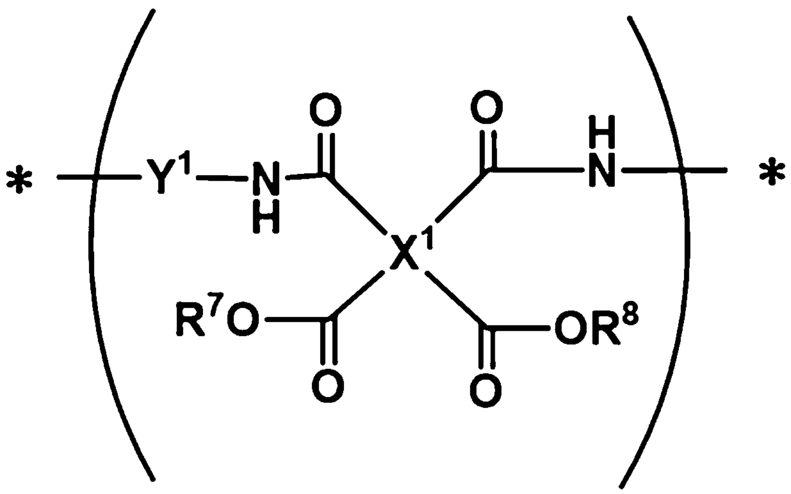
(3)

In the formulas (6), (7), and (3), $X^1$ represents a tetravalent organic group having 2 to 40 carbon atoms and having any of an aliphatic structure having 2 to 20 carbon atoms, an alicyclic structure having 4 to 20 carbon atoms, and an aromatic structure having 6 to 40 carbon atoms. $Y^1$ represents a divalent organic group having 2 to 40 carbon atoms and

having any structure among an aliphatic structure having 2 to 20 carbon atoms, an alicyclic structure having 4 to 20 carbon atoms, and an aromatic structure having 6 to 40 carbon atoms. $R^7$ and $R^8$ each independently represent a hydrogen atom, an alkyl group having 1 to 20 carbon atoms, or a monovalent organic group having an ethylenically unsaturated double bond. Each * represents a bonding site.

The structural unit represented by the formula (6) represents a structural unit in which all the amic acid structures or all the amic acid ester structures in the structural unit are ring-closed and imidized. The formula (7) represents a structural unit in which part of the amic acid structures or the amic acid ester structures in the structural unit are ring-closed and imidized, and part thereof are amic acid structures or amic acid ester structures. The formula (3) represents a structural unit in which the amic acid structures or the amic acid ester structures in the structural unit are not ring-closed, and all of them are amic acid structures or amic acid ester structures.

Where the numbers of the structural unit represented by the formula (6), the structural unit represented by the formula (7), and the structural unit represented by the formula (3) in the polyimide resin (A1) are denoted by p, q, and r, respectively, p, q, and r are integers of 0 or more. Among them, it is preferable that r is an integer of 1 or more, and the polyimide resin (A1) has a structural unit represented by the formula (3). The fact that the component (A) includes the polyimide resin (A1) and the polyimide resin (A1) has a structure represented by the formula (3) is preferable because a photosensitive agent is added to the polyimide resin (A1) to form a photosensitive resin composition, sensitivity can be improved and development residues can be reduced. $R^7$ and $R^8$ in the formula (3) are each independently preferably an alkyl group having 1 to 10 carbon atoms or a monovalent organic group having an ethylenically unsaturated double bond, and more preferably an alkyl group having 1 to 3 carbon atoms or a monovalent organic group having an ethylenically unsaturated double bond. When $R^7$ and $R^8$ are each an alkyl group having 1 to 10 carbon atoms or a monovalent organic group having an ethylenically unsaturated double bond, solubility in a developer can be adjusted to a preferable range, so that a good pattern shape can be obtained. In addition, the fact that $R^7$ and $R^8$ are each a monovalent organic group having an ethylenically unsaturated double bond is preferable because in addition to the above-described effect, the progress of the crosslinking reaction during heat curing can improve breaking elongation and chemical resistance. Examples of the alkyl group include a methyl group, an ethyl group, a propyl group, an isopropyl group, a butyl group, an isobutyl group, a t-butyl group, a pentyl group, and a hexyl group, and examples of the monovalent organic group having an ethylenically unsaturated double bond include a structure in which a hydroxyl group is removed from 2-hydroxyethyl methacrylate (HEMA) or 2-hydroxyethyl acrylate.

In addition, $Y^1$ in the formula (3) is preferably a divalent organic group represented by formula (4) or formula (5).

[Chemical Formula 9]

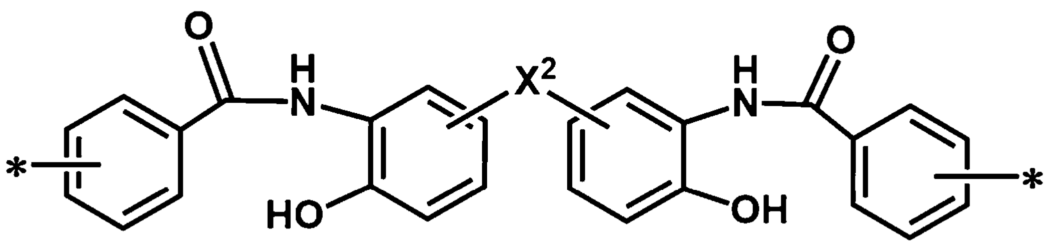

(4)

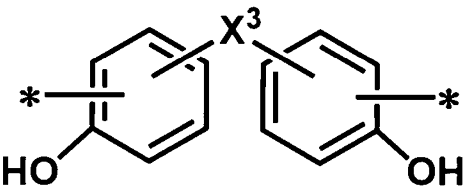

(5)

In the formulas (4) and (5), $X^2$ and $X^3$ each independently represent a direct bond, $-SO_2-$, -O-, or a divalent organic group having 1 to 20 carbon atoms. Each * represents a bonding point bonded to an amide structure, an imide structure, an amic acid ester structure, or an amic acid structure.

Since the structures represented by the formulas (4) and (5) have a phenolic hydroxyl group, solubility in an alkaline developer can be imparted, and development residues can be reduced. The fact that $X^2$ and $X^3$ are each independently any one selected from the group consisting of $-C(CF_3)_2-$, $-CH(CF_3)-$, and $-C(CH_3)_2-$ is preferable because intermolecular packing is suppressed, and solvent solubility can be improved. In addition, the fact that $X^2$ and $X^3$ are each independently a divalent organic group having 1 to 20 carbon atoms and containing no fluorine atom is preferable because metal adhesion after PCT treatment can be improved.

The imide ring closure rate of the polyimide resin (A1) is preferably 1% or more and 98% or less, more preferably 1% or more and 70% or less, and still more preferably 1% or more and 50% or less. The fact that the imide ring closure rate is 1% or more is preferable because the amount of outgas at high temperature can be reduced, and high reliability of an organic EL display device can be improved. In addition, the fact that the imide ring closure rate is 98% or less is preferable because residues after development can be reduced, and the sensitivity of the resin composition can be increased.

The imide ring closure rate of the polyimide resin (A1) is determined by the method described later.

The polyimide resin (A1) may be a copolymer having one or more selected from the group consisting of a structural unit represented by the formula (6), a structural unit represented by the formula (7), and a structural unit represented by the formula (3), and a structural unit other than the structural unit represented by the formula (6), the structural unit represented by the formula (7), and the structural unit represented by the formula (3). In the case of the copolymer, the copolymer is preferably a copolymer with a structural unit of polybenzoxazole described later.

In a preferable embodiment, the polybenzoxazole resin (A2) can be obtained, for example, by reacting a bisaminophenol compound with a dicarboxylic acid, its corresponding dicarboxylic acid chloride, or dicarboxylic acid active ester, and has a dicarboxylic acid residue and a bisaminophenol residue. In addition, the reaction product thus obtained may be dehydratively cyclized by heating or a reaction using an acid, a base, acetic anhydride, a carbodiimide compound, or the like.

The polybenzoxazole resin (A2) preferably has, for example, one or more selected from the group consisting of a structural unit represented by formula (8), a structural unit represented by formula (9), and a structural unit represented by formula (10).

[Chemical Formula 10]

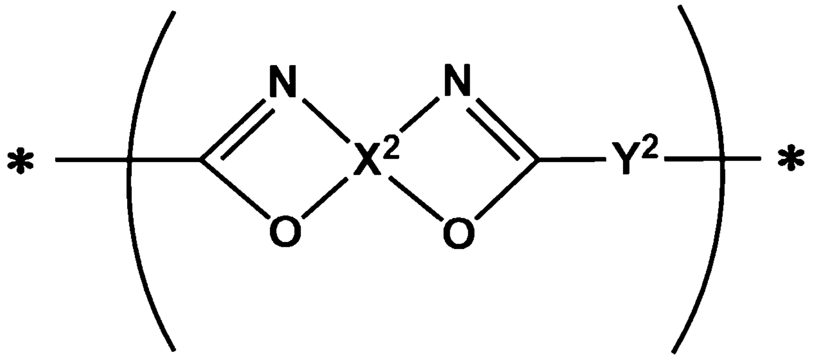

(8)

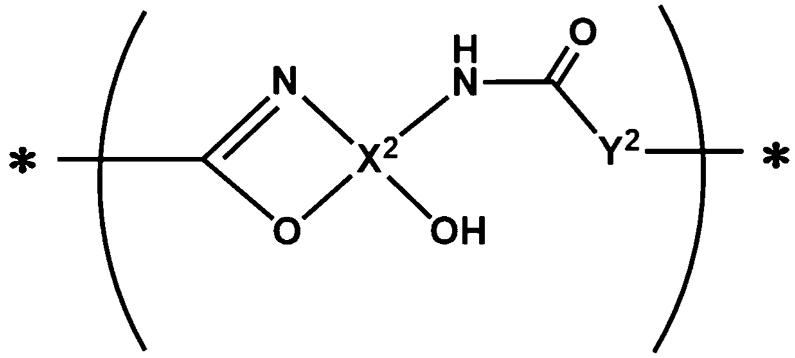

(9)

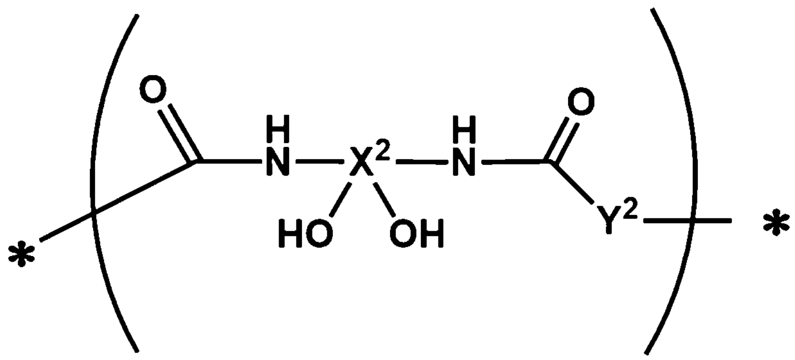

(10)

In the formulas (8), (9), and (10), $X^2$ represents a dicarboxylic acid residue, and $Y^2$ represents a bisaminophenol residue. The dicarboxylic acid residue has a structure obtained by removing two carboxyl groups from a dicarboxylic acid compound. The bisaminophenol residue has a structure obtained by removing two amino groups and two hydroxyl groups from a bisaminophenol compound.

The formula (8) represents a structural unit in which all hydroxyamide structures in the structural unit are ring-closed and oxazolated. The formula (9) represents a structural unit in which part of the hydroxyamide structures in the structural unit are ring-closed and oxazolated, and part thereof are hydroxyamide structures. The formula (10) represents a structural unit in which the hydroxyamide structures in the structural unit are not ring-closed, and all thereof are hydroxyamide structures.

Where the numbers of the structural unit represented by the formula (8), the structural unit represented by the formula (9), and the structural unit represented by the formula (10) in the polybenzoxazole resin (A2) are denoted by s, t, and u, respectively, s, t, and u are integers of 0 or more.

The oxazole ring closure rate (hereinafter sometimes referred to as $R_{OX}$) of the polybenzoxazole resin (A2) is preferably 0% or more and 90% or less, more preferably 0% or more and 70% or less, and still more preferably 0% or more and 50% or less. When the oxazole ring closure rate is within the above range, residues after development can be reduced.

The oxazole ring closure rate of the polybenzoxazole resin (A2) is determined by the following method.

<Oxazole ring closure rate ($R_{OX}$ (%))>

The polybenzoxazole resin (A2) is dissolved in γ-butyrolactone (hereinafter GBL) such that a concentration thereof is 35 mass%. This solution is applied onto a 4 inch silicon wafer by a spin coating method using a spin coater 1H-DX (manufactured by Mikasa Co., Ltd.), and then baked on a hot plate at 120°C for 3 minutes, whereby a resin film having a thickness of 4 to 5 μm is prepared. The wafer with the resin film is divided into two halves, and one is cured under a nitrogen stream (oxygen concentration: 20 ppm or less) at 140°C for 30 minutes using a clean oven CLH-21CD-S (manufactured by Koyo Thermo Systems Co., Ltd.), and then at 370°C for 1 hour following raising of the temperature. Thus, an oxazole ring is completely closed. The transmitted infrared absorption spectra of the resin film before and after the curing were measured with an infrared spectrophotometer FT-720 (manufactured by HORIBA, Ltd.). The intensities of the peak (around 1,050 $cm^{-1}$) attributable to C-O stretching vibration of oxazole (before curing: U, after curing: W) are determined. The peak intensity ratio obtained by dividing the peak intensity (U) by the peak intensity (W) is calculated by the following equation, and defined as the content of oxazole groups in the polymer before heat treatment, that is, the oxazole ring closure rate.

$$R_{OX}\ (\%) = (U/W) \times 100$$

The polybenzoxazole resin (A2) may be a copolymer having one or more selected from the group consisting of a structural unit represented by the formula (8), a structural unit represented by the formula (9), and a structural unit represented by the formula (10), and a structural unit other than the structural unit represented by the formula (8), the structural unit represented by the formula (9), and the structural unit represented by the formula (10). In the case of the copolymer, the copolymer is preferably a copolymer with a structural unit of polyimide described above.

The copolymer resin (A3) can, for example, be obtained as a random copolymer by reacting a raw material of the polyimide resin (A1) and a raw material of the polybenzoxazole resin (A2) at a time, or can be obtained as a block copolymer having a structural unit of polyimide and a structural unit of polybenzoxazole by separately synthesizing a structural unit of polyimide and a structural unit of polybenzoxazole and then reacting these structural units.

The copolymer resin (A3) preferably has, for example, both one or more selected from the group consisting of a structural unit represented by the formula (6), a structural unit represented by the formula (7), and a structural unit represented by the formula (3), which are structural units of polyimide, and one or more selected from the group consisting of a structural unit represented by the formula (8), a structural unit represented by the formula (9), and a structural unit represented by the formula (10), which are structural units of polybenzoxazole.

In addition, similarly to the polyimide resin (A1), the copolymer resin (A3) preferably has a structural unit represented by the formula (3). The fact that the component (A) includes the copolymer resin (A3) and the copolymer resin (A3) has a structure represented by the formula (3) is preferable because a photosensitive agent is added to the copolymer resin (A3) to form a photosensitive resin composition, sensitivity can be improved and development residues can be reduced.

In addition, similarly to the polyimide resin (A1), it is preferable that the copolymer resin (A3) has a structural unit represented by the formula (3), and $Y^1$ in the formula (3) is a divalent organic group represented by the formula (4) or (5). Since the structures represented by the formulas (4) and (5) have a phenolic hydroxyl group, solubility in an alkaline developer can be imparted, and development residues can be reduced. The fact that $X^2$ and $X^3$ are each independently any one selected from the group consisting of $-C(CF_3)_2-$, $-CH(CF_3)-$, and $-C(CH_3)_2-$ is preferable because intermolecular packing is suppressed, and solvent solubility can be improved. In addition, the fact that $X^2$ and $X^3$ are each independently a divalent organic group having 1 to 20 carbon atoms and containing no fluorine atom is preferable because metal adhesion after PCT treatment can be improved.

The fact that the component (A) includes a polyimide resin (A1) and/or a copolymer resin (A3) of a structural unit of a polyimide resin and a structural unit of a polybenzoxazole resin, and the component (A) contains a structural unit represented by formula (3) is preferable because when a photosensitive resin composition is formed, sensitivity can be improved and development residues can be reduced.

The component (A) can be synthesized by a known method. Hereinafter, methods for synthesizing the polyimide resin (A1), the polybenzoxazole resin (A2), and the copolymer resin (A3) will be described with reference to examples.

The polyimide resin (A1) can be synthesized by, as a production method thereof, for example, a method of allowing a tetracarboxylic dianhydride and a diamine compound to undergo a reaction in a polymerization solvent at a low temperature, a method of obtaining a diester from a tetracarboxylic dianhydride and an alcohol, and then allowing the diester to undergo a reaction with an amine in the presence of a condensing agent, a method of obtaining a diester from a tetracarboxylic dianhydride and an alcohol, and then turning the residual dicarboxylic acid into an acid chloride, and allowing the acid chloride to undergo a reaction with an amine, or the like. The resin obtained by the above method may be dehydratively cyclized by heating or chemical treatment with an acid, a base, or the like.

The polybenzoxazole resin (A2) can be produced, for example, by making a bisaminophenol compound and a dicarboxylic acid undergo a condensation reaction in a polymerization solvent. Specifically, examples of the production

method include a method of making a dehydrative condensing agent such as dicyclohexylcarbodiimide (hereinafter DCC) and an acid to undergo a reaction and adding a bisaminophenol compound thereto, and a method of adding a solution of a dicarboxylic acid dichloride dropwise into a solution of a bisaminophenol compound with a tertiary amine such as pyridine added thereto.

The copolymer resin (A3) can be synthesized, for example, by combining the method for synthesizing the polyimide resin (A1) and the method for synthesizing the polybenzoxazole resin (A2).

The component (A) polymerized by the above method is desirably charged into a large amount of deionized water or a mixed solution of methanol/deionized water, precipitated, collected by filtration, dried, and isolated. This precipitation procedure enables the removal of unreacted monomers or an oligomer component, e.g., a dimer and a trimer, thereby improving the film properties and the chemical resistance after heat curing.

The polymerization solvent is merely required to dissolve acid dianhydrides and diamines as raw material monomers, and the type thereof is not particularly limited. Examples of the polymerization solvent include amides such as N,N-dimethylformamide (hereinafter DMF), N,N-diethylformamide, N,N-dimethylacetamide (hereinafter DMAc), N-methyl-2-pyrrolidone (hereinafter NMP), N-ethyl-2-pyrrolidone, 1,3-dimethyl-2-imidazolidinone (hereinafter DMI), 3-methoxy-N,N-dimethylpropanamide (hereinafter MPA), 3-butoxy-N,N-dimethylpropanamide (hereinafter BPA), N,N'-dimethylpropyleneurea, N,N-dimethylisobutylamide (hereinafter DMIB), N,N-dimethylpropionamide (hereinafter DMPA), and 3-methyl-2-oxazolidone; cyclic esters such as $\gamma$-butyrolactone (hereinafter GBL), $\gamma$-valerolactone, $\delta$-valerolactone, $\gamma$-caprolactone, $\varepsilon$-caprolactone, and $\alpha$-methyl-$\gamma$-butyrolactone; carbonates such as ethylene carbonate and propylene carbonate; glycols such as triethylene glycol; phenols such as m-cresol and p-cresol; esters such as methyl levulinate, ethyl levulinate, propyl levulinate, butyl levulinate, ethyl levulinate propylene glycol ketal, and ethyl levulinate glycerol ketal; acetophenone, sulfolane, dimethyl sulfoxide (hereinafter DMSO), and dihydrolevoglucosenone (hereinafter Cyrene, manufactured by Circa).

The amount of the polymerization solvent used is preferably 100 to 1,900 parts by mass, and more preferably 150 to 950 parts by mass based on 100 parts by mass of the component (A).

The resin composition of the present invention includes a component (B) being levoglucosenone and/or dihydrolevoglucosenone. Levoglucosenone refers to a compound represented by formula (11), and dihydrolevoglucosenone refers to a compound represented by formula (12).

[Chemical Formula 11]

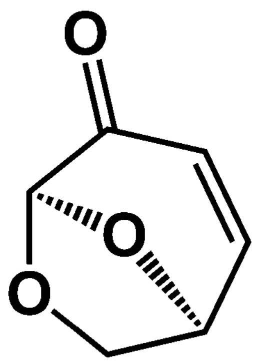
(11)

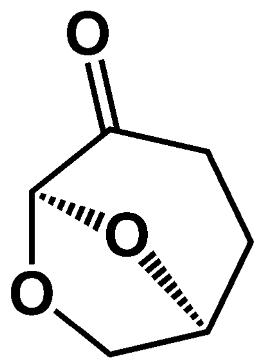
(12)

These compounds may be added as an additive when the resin composition is prepared, or may be used as a solvent of the resin composition. When the resin composition includes the component (B), the flatness of the resin composition can be improved, and the breaking elongation and chemical resistance of a cured film obtained by curing the resin composition can be improved. In the present description, the flatness refers to a property of reducing the unevenness of the substrate surface, that is, flattening the substrate surface by applying the resin composition onto a substrate with unevenness, followed by curing. Although the detailed mechanism is unknown, the principle of obtaining the above effect is estimated as follows.

Regarding the improvement in flatness, since levoglucosenone and dihydrolevoglucosenone are compounds having a polarity close to that of the polyimide resin or the polybenzoxazole resin, it is presumed that levoglucosenone and dihydrolevoglucosenone strongly interact with the polyimide resin or the polybenzoxazole resin. Since both levoglucosenone and dihydrolevoglucosenone have a high boiling point, it is considered that levoglucosenone and dihydrolevoglucosenone remain in a resin film for a long time during a heat curing step. (Boiling point of levoglucosenone: 231°C, boiling point of dihydrolevoglucosenone: 227°C (both are boiling points at atmospheric pressure)) Therefore, it is considered that levoglucosenone and dihydrolevoglucosenone act as plasticizers in the resin film in the heat curing step to impart fluidity during heat curing, and as a result, flatness of the resin film is improved. The resin film is a film formed

by applying a resin composition to a substrate.

In addition, regarding improvement in the breaking elongation and chemical resistance of the cured film, when Hansen solubility parameters of levoglucosenone and dihydrolevoglucosenone and general-purpose polar solvents such as NMP and DMF are compared, it can be found that levoglucosenone and dihydrolevoglucosenone have higher polarity terms. Accordingly, it is considered that levoglucosenone and dihydrolevoglucosenone promote nucleophilic reactions in the reaction system, and can promote the cyclization reactions of the polyimide resin and the polybenzoxazole resin, and as a result, a cured film excellent in breaking elongation and chemical resistance can be obtained. In addition, when the resin composition includes a crosslinking agent described later, it is considered that levoglucosenone and dihydrolevoglucosenone can also promote a reaction in which the crosslinking agent is added to the resins, and therefore it is considered that the resin composition of the present invention can further improve the breaking elongation and the chemical resistance due to the inclusion of the crosslinking agent.

The content of the component (B) is preferably 1 to 3,000 parts by mass, more preferably 20 to 2,000 parts by mass, and still more preferably 50 to 1,000 parts by mass based on 100 parts by mass of the total amount of the component (A). Within the above range, the effects of improving the flatness, improving the breaking elongation of the cured film, and improving the chemical resistance are easily obtained.

The component (B) refers to levoglucosenone or dihydrolevoglucosenone, but the resin composition of the present invention preferably includes dihydrolevoglucosenone as the component (B). When dihydrolevoglucosenone is included as the component (B), the flatness and storage stability of the resin composition can be improved, and also the chemical resistance, breaking elongation, adhesion to metals, and transparency of a cured film obtained by curing the resin composition can be improved.

The resin composition of the present invention preferably further includes the component (C) being a compound represented by formula (1) and/or a compound represented by formula (2).

[Chemical Formula 12]

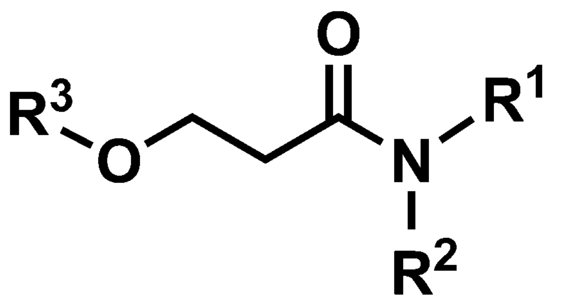

(1)

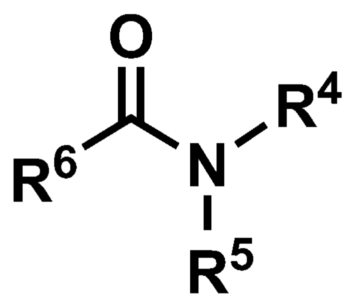

(2)

In the formula (1), $R^1$, $R^2$ and $R^3$ are each independently an alkyl group having 1 to 6 carbon atoms. In the formula (2), $R^4$ and $R^5$ are each independently an alkyl group having 1 to 6 carbon atoms. $R^6$ is a hydrogen atom or an alkyl group having 1 to 6 carbon atoms.

When the component (C) is included, the cyclization reaction of the component (A) is promoted, and the breaking elongation and the chemical resistance can be improved. In addition, since the component (C) strongly interacts with the component (A) and a metal material, adhesion to the metal material can be improved due to the inclusion of the component (C).

A β-alkoxypropionamide as the compound represented by the formula (1) is preferably MPA or BPA from the viewpoint of the solubility of the component (A), promoting the cyclization reaction of the component (A), and improving the

breaking elongation and the chemical resistance of a cured film.

In the present invention, the content of the β-alkoxypropionamide is preferably 0.1 parts by mass or more, more preferably 1 part by mass or more based on 100 parts by mass of the component (A) from the viewpoint of promoting the cyclization reaction of the component (A) and improving the breaking elongation and the chemical resistance of the cured film. On the other hand, the content is preferably 15 parts by mass or less, and more preferably 10 parts by mass or less from the viewpoint of successfully forming a desired patterned film in use as a development film.

The compound represented by the formula (2) is preferably DMPA or DMIB from the viewpoint of promoting the cyclization reaction of the component (A), and improving the breaking elongation and the chemical resistance of a cured film.

In the present invention, the content of the compound represented by the formula (2) is preferably 0.1 parts by mass or more, more preferably 1 part by mass or more based on 100 parts by mass of the component (A) from the viewpoint of promoting the cyclization reaction of the component (A) and improving the breaking elongation and the chemical resistance of the cured film. On the other hand, the content is preferably 15 parts by mass or less, and more preferably 10 parts by mass or less from the viewpoint of successfully forming a desired patterned film in use as a development film.

In the resin composition of the present invention, where a mass of the component (B) contained in the resin composition is denoted by X and a mass of the component (C) contained in the resin composition is denoted by Y, the ratio X/Y is preferably 1 or more and 1,000 or less, more preferably 5 or more and 500 or less, still more preferably 10 or more and 450 or less, and particularly preferably 15 or more and 400 or less. As described above, both the component (B) and the component (C) can improve the breaking elongation and the chemical resistance of the cured film, but when X/Y is within the above range, the breaking elongation and the chemical resistance of the cured film can be improved without deteriorating the flatness of the resin composition and the adhesion of the cured film to a metal material.

The resin composition of the present invention preferably further includes a component (D) being a compound having a hydroxyl group and having a boiling point at atmospheric pressure of 100°C or more and 200°C or less. When the component (D) is included, the flatness can be improved, and the developability is improved, so that generation of development residues can be suppressed, and sensitivity can be improved.

Examples of the component (D) include propylene glycol monomethyl ether (hereinafter PGME; boiling point: 120°C), methyl lactate (boiling point: 145°C), ethyl lactate (boiling point: 154°C), propyl lactate (boiling point: 169°C), 1-butanol (boiling point: 117°C), 1-pentanol (boiling point: 138°C), 1-hexanol (boiling point: 157°C), cyclohexanol (boiling point: 161°C), 3-methoxybutanol (boiling point: 161°C), ethylene glycol monomethyl ether (boiling point: 124°C), diacetone alcohol (boiling point: 166°C), tetrahydrofurfuryl alcohol (boiling point: 176°C), and diethylene glycol monomethyl ether (boiling point: 194°C).

The content of the component (D) contained in the resin composition of the present invention is preferably 5 to 3,000 parts by mass, and more preferably 10 to 1,000 parts by mass based on 100 parts by mass of the total amount of the component (A).

The ratio X/Z of the mass X of the component (B) to the mass Z of the component (D) contained in the resin composition of the present invention is preferably 0.01 to 10, more preferably 0.05 to 5, still more preferably 0.08 to 2, and particularly preferably 0.1 to 1. When the ratio X/Z is within the above range, it is possible to satisfy all the characteristics of improvement in flatness, suppression of development residues, and improvement in adhesion and sensitivity.

The resin composition of the present invention preferably includes a component (E) being a photosensitive agent. When the component (E) is included, photosensitivity can be imparted to the resin composition. Examples of the component (E) include a component (E2) being a photoacid generator and a component (E1) being a photo initiator. When the component (E2) being a photoacid generator is included, it is possible to obtain a positive type relief pattern in which an acid is generated in a part irradiated with light, so that the solubility of the part irradiated with light in an alkaline aqueous solution is increased and the part irradiated with light dissolves. When the component (E2) being a photoacid generator and the component (I) being a crosslinking agent are included, it is possible to obtain a negative type relief pattern in which an acid generated in a part irradiated with light promotes the crosslinking reaction of the component (I), so that the part irradiated with light is insolubilized. When the component (E1) being a photo initiator and the component (F) that is a radical polymerizable compound are included, it is possible to obtain a negative type relief pattern in which active radicals generated in a part irradiated with light promote radical polymerization of ethylenically unsaturated bonds in the radical polymerizable compound, so that the part irradiated with light is insolubilized. It is preferable that the component (E1) includes a component (E1-1) being an oxime ester photoinitiator and/or a component (E1-2) being a titanocene photoinitiator, and further includes the component (F) that is a radical polymerizable compound. When the resin composition includes the component (E1-1) and/or the component (E1-2), and further includes the component (F), the sensitivity of the resin composition can be increased. In the resin composition of the present invention, it is preferable that the component (E) being a photosensitive agent includes the component (E2) that is a photoacid generator, and exhibits positive photosensitivity. When the component (E) being a photosensitive agent includes the component (E2) being a photoacid generator, and exhibits positive photosensitivity, it becomes easy to reduce variations in the opening dimension of the pattern by a processing process. In addition, when the component (E) beings a photosensitive agent

includes the component (E1) being a photo initiator and the component (F) being a radical polymerizable compound, and exhibits negative photosensitivity, the sensitivity of the photosensitive resin composition can be enhanced.

Examples of the component (E2) being a photoacid generator include quinone diazide compounds, sulfonium salts, phosphonium salts, diazonium salts, and iodonium salts.

Examples of the quinone diazide compound include compounds in which a sulfonic acid of quinone diazide is bonded to a polyhydroxy compound by an ester, compounds in which a sulfonic acid of quinone diazide is sulfonamide-bonded to a polyamino compound, and compounds in which a sulfonic acid of quinone diazide is ester-bonded and/or sulfonamide-bonded to a polyhydroxypolyamino compound. It is preferable that 50 mol% or more of the whole functional groups of these polyhydroxy compounds and polyamino compounds are substituted with quinone diazide. In addition, it is preferable that two or more types of the component (E2) being a photoacid generator are included, and a highly sensitive photosensitive resin composition can thereby be obtained.

In the present invention, as the quinone diazide, either one having a 5-naphthoquinone diazide sulfonyl group or one having a 4-naphthoquinone diazide sulfonyl group is suitably used. A 4-naphthoquinone diazide sulfonyl ester compound has absorption in an i-line region of a mercury lamp, and is therefore suitable for the exposure to i-line. Absorption of a 5-naphthoquinone diazide sulfonyl ester compound extends to the g-line region of the mercury lamp, and the 5-naphthoquinone diazide sulfonyl ester compound is suitable for exposure to g-line. In the present invention, it is preferable to select a 4-naphthoquinone diazide sulfonyl ester compound or a 5-naphthoquinone diazide sulfonyl ester compound depending on the wavelength for exposure. A naphthoquinone diazide sulfonyl ester compound having a 4-naphthoquinone diazide sulfonyl group and a 5-naphthoquinone diazide sulfonyl group in one molecule may be included, or both a 4-naphthoquinone diazide sulfonyl ester compound and a 5-naphthoquinone diazide sulfonyl ester compound may be included.

Among the components (E2) being photoacid generators, sulfonium salts, phosphonium salts, and diazonium salts are preferable because these appropriately stabilize the acid component generated by exposure. In particular, sulfonium salts are preferable.

As the component (E1) being a photo initiator, for example, the photo initiators described in [0223] to [0276] of WO 2019/087985 A and [0047] to [0048] of WO 2019/194286 A can be used. Among them, from the viewpoint of achieving high sensitivity, the component (E1) preferably includes a component (E1-1) being an oxime ester photoinitiator and/or a component (E1-2) being a titanocene photoinitiator. Two or more of these may be included.

The content of the component (E) being a photosensitive agent is preferably 0.5 to 50 parts by mass based on 100 parts by mass of the component (A).

In the component (E) being a photosensitive agent, the content of the component (E2) being a photoacid generator is preferably 0.5 to 50 parts by mass based on 100 parts by mass of the component (A) from the viewpoint of increasing the sensitivity. Among them, the amount of the quinone diazide compound is preferably 3 to 40 parts by mass. The total amount of the sulfonium salt, phosphonium salt, and diazonium salt is preferably 0.5 to 20 parts by mass.

In the component (E) being a photosensitive agent, the content of the component (E1) being a photo initiator is preferably 0.5 to 20 parts by mass based on 100 parts by mass of the component (A). When the content of the component (E1) is 0.5 parts by mass or more, sufficient radicals are generated by light irradiation, and sensitivity is improved. When the content of the component (E1) is 20 parts by mass or less, curing in unirradiated portions due to excessive radical generation does not take place and the alkali developability is improved.

The resin composition of the present invention may further include a component (F) being a radical polymerizable compound, and a component (E) being a photosensitive agent may include a component (E1) being a photo initiator. By adopting such a configuration, it is possible as described above to obtain a negative type relief pattern in which active radicals generated in the part irradiated with light cause radical polymerization of the ethylenically unsaturated bond in the radical polymerizable compound to proceed and the part irradiated with light is insolubilized. As a result, the photosensitive resin composition becomes a negative photosensitive resin composition.

Examples of the component (F) being a radical polymerizable compound include the radical polymerizable compounds described in [0189] to [0222] of WO 2019/087985 A. Among them, it is preferable that a flexible chain-containing aliphatic radical polymerizable compound is included. The flexible chain-containing aliphatic radical polymerizable compound refers to a compound having a plurality of ethylenically unsaturated double bond groups and a flexible skeleton such as an aliphatic chain or an oxyalkylene chain in the molecule.

When the flexible chain-containing aliphatic radical polymerizable compound is included, a curing reaction during light irradiation proceeds efficiently, so that the sensitivity during light irradiation can be improved. Furthermore, the change in pattern opening width dimension between before and after thermal curing can be suppressed. The content of the component (F) being a radical polymerizable compound is preferably 5 to 50 parts by mass based on 100 parts by mass of the component (A).

The resin composition of the present invention may include a component (G) being a solvent other than the component (B), the component (C), and the component (D). Examples of the component (G) include ethers such as ethylene glycol monoethyl ether, propylene glycol monoethyl ether, diethylene glycol dimethyl ether, and diethylene glycol

ethyl methyl ether, esters such as ethylene glycol monomethyl ether acetate, propylene glycol monomethyl ether acetate, ethyl acetate, butyl acetate, and butyl lactate, alcohols such as methanol, ethanol, and isopropanol, ketones such as methyl ethyl ketone, methyl isobutyl ketone, methyl amyl ketone, diisobutyl ketone, cyclopentanone, and diacetone alcohol, polar aprotic solvents such as NMP, GBL, DMSO, 1,3-dimethyl-2-imidazolidinone, and 3-methyl-2-oxazolidone, and aromatic hydrocarbons such as toluene and xylene. Two or more of these solvents may be included.

The content of the component (G) is preferably 1,500 parts by mass or less, and more preferably 1,000 parts by mass or less based on 100 parts by mass of the component (A) .

The resin composition of the present invention may be designed to be a positive photosensitive resin composition in which a component (H) being a dissolution accelerator is further included and the component (E) being the photosensitive agent includes a component (E2) being a photoacid generator. The component (H) compensates for the alkali developability of the photosensitive resin composition, and can improve the sensitivity in the positive photosensitive resin composition. The component (H) is preferably a compound having a phenolic hydroxyl group, and examples thereof include compounds having a phenolic hydroxyl group such as Bis-z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-Pz, BisP-IPZ, BisCRIPZ, BisOCP-IPZ, BisOIPP-CP, Bis26X-IPZ, BisOTBP-CP, TekP4HBPA (tetrakis P-DO-BPA), TrisPHAP, TrisP-PA, TrisP-PHBA, TrisP-SA, TrisOCRPA (trade names, manufactured by Honshu Chemical Industry Co., Ltd.), MILEX HBPX, MILEX PIRM, MILEX MDPR (trade names, manufactured by Mitsui Chemicals, Inc.), BIR-OC, BIP-PC, BIR-PC, BIR-PTBP, BIR-PCHP, BIP-BIOCF, 4PC, BIR-BIPC-F, TEP-BIP-A (trade names, manufactured by Asahi Yukizai Corporation), bisphenol A, bisphenol AF (hereinafter BPAF), bisphenol B, bisphenol C, bisphenol S, 1,4-dihydroxynaphthalene, 1,5-dihydroxynaphthalene, 1,6-dihydroxynaphthalene, 1,7-dihydroxynaphthalene, 2,3-dihydroxynaphthalene, 2,6-dihydroxynaphthalene, 2,7-dihydroxynaphthalene, 2,4-dihydroxyquinoline, 2,6-dihydroxyquinoline, 2,3-dihydroxyquinoxaline, anthracene-1,2,10-triol, anthracene-1,8,9-triol, and 8-quinolinol.

The content of the component (H) being a dissolution accelerator is preferably 1 to 40 parts by mass based on 100 parts by mass of the component (A) from the viewpoint that the sensitivity can be improved while the pattern shape is kept good.

The resin composition of the present invention preferably includes a component (I) being a crosslinking agent. The crosslinking agent refers to a compound having a crosslinkable group capable of binding to a resin. When the component (I) is included, the breaking elongation and the chemical resistance of a cured film can be improved. This is speculated to be because the component (I) can introduce a new crosslinking structure to the cured film of the resin composition, so that the crosslink density increases.

As the component (I), a compound having, in the molecule, two or more thermal crosslinkable properties, such as an alkoxymethyl group, a methylol group, an epoxy group, or an oxetanyl group, is preferable.

As examples of the component (I), the crosslinking agents described in [0407] to [0412] of WO 2019/087985 A can be used.

The content of the component (I) is preferably 0.5 to 50 parts by mass based on 100 parts by mass of the component (A). When the content is 0.5 to 50 parts by mass, the breaking elongation and the chemical resistance of a cured film can be improved without deteriorating the storage stability of the resin composition and the transparency of the cured film.

The resin composition of the present invention may further include a component (J) being a surfactant. The surfactant refers to a compound having a hydrophilic structure and a hydrophobic structure. When the component (J) is included in an appropriate amount, the surface tension of the resin composition can be arbitrarily adjusted, and the leveling property at the time of application improves, and the film thickness uniformity of the coating film can be improved. As the component (J), a fluororesin-based surfactant, a silicone-based surfactant, a polyoxyalkylene ether-based surfactant, or an acrylic resin-based surfactant is preferable.

As specific examples of the component (J), surfactants described in [0419] to [0420] of WO 2019/087985 A can be used.

The content ratio of the component (J) in the resin composition of the present invention is preferably 0.001 mass% or more, and more preferably 0.005 mass% or more based on the whole resin composition. When the content ratio is 0.001 mass% or more, the leveling property at the time of application can be improved. On the other hand, the content ratio of the surfactant is preferably 1 mass% or less, and more preferably 0.5 mass% or less. When the content ratio is 1 mass% or less, defects generated at the time of application can be reduced.

The resin composition of the present invention may include a component (K) being an additive other than those described above. Examples of the component (K) include the polyfunctional thiol compounds described in [0386] to [0398] of WO 2019/087985 A, the colorants described in [0281] to [0370] of WO 2019/087985 A, the dispersants described in [0371] to [0385] of WO 2019/087985 A, the sensitizers described in [0399] to [0402] of WO 2019/087985 A, the polymerization inhibitors described in [0403] to [0406] of WO 2019/087985 A, the silane coupling agents described in [0413] to [0418] of WO 2019/087985 A, and the inorganic particles described in [0127] to [0130] of WO 2016/052268 A and [0024] to [0025] of WO 2019/167461 A.

Examples of the method for producing the resin composition of the present invention include a method of putting the component (A) and the component (B) and, as necessary, other components in a glass flask or a stainless steel container, followed by stirring and dissolving the mixture with a mechanical stirrer or the like, a method of dissolving the components by ultrasonic waves, and a method of stirring and dissolving the components with a planetary stirring and defoaming apparatus.

The obtained resin composition is preferably filtered by the use of a filtration filter to remove dust and particles. The pore size of the filtration filter is 0.5 to 0.02 μm, for example, 0.5 μm, 0.2 μm, 0.1 μm, 0.05 μm, and 0.02 μm, but is not limited thereto. The material of the filtration filter may be polypropylene, polyethylene, nylon, polytetrafluoroethylene, or the like, and polyethylene and nylon are preferred. When the resin composition contains inorganic particles, a pigment, or the like, it is preferable to use a filtration filter having a pore size larger than the inorganic particles, the pigment, or the like.

The cured film of the present invention is obtained by curing the resin composition of the present invention. Examples of the method of curing the resin composition include a method of curing the resin composition by heating, and a method of irradiating the resin composition with active actinic rays. By curing the resin composition of the present invention, the heat resistance, the breaking elongation, and the chemical resistance of the cured film can be improved.

Next, a method for producing the cured film of the present invention will be described.

The method for producing the cured film of the present invention preferably includes the steps of (1), (2), and (5). In addition, when the resin composition of the present invention includes the component (E) being a photosensitive agent and has photosensitivity, it is preferable that the method includes the steps of (3) and (4) in addition to the aforementioned steps.

(1) A step of applying the resin composition described above to a substrate to form a resin film;
(2) a step of drying the resin film;
(3) a step of exposing the dried resin film to light through a photomask;
(4) a step of developing the exposed resin film; and
(5) a step of subjecting the developed resin film to a heating treatment.

In the step (1), the resin composition of the present invention is applied by a spin coating method, a slit coating method, a dip coating method, a spray coating method, a printing method, or the like to afford a resin film of the resin composition. Prior to the application, a substrate to which the resin composition is applied may be pretreated with an adhesion promoter. Examples of the pretreatment include a method of treating the substrate surface with the use of a solution prepared by dissolving an adhesion promoter in a content of 0.5 to 20 mass% in a solvent such as isopropanol, ethanol, methanol, water, tetrahydrofuran, propylene glycol monomethyl ether acetate, propylene glycol monomethyl ether, ethyl lactate, or diethyl adipate. Examples of the method for treating the substrate surface include spin coating, slit die coating, bar coating, dip coating, spray coating, and steam treatment. Examples of the adhesion promoter include the adhesion promoter described in [0127] of WO 2019/065351 A.

In the step (2), the resin film applied may be optionally subjected to a reduced-pressure drying treatment, and is then subjected to a heating treatment at 50°C to 180°C for 1 minute to several hours using a hot plate, an oven, infrared ray or the like to afford a resin film.

In the step (3), the resin film is irradiated with actinic rays through a photomask having a desired pattern. Examples of the actinic ray to be employed for the exposure to light include ultraviolet ray, visible light, electron beam and X-ray. In the present invention, it is preferable to use i-line (365 nm), h-line (405 nm) or g-line (436 nm) of a mercury lamp. After the irradiation with the actinic rays, post-exposure baking may be conducted. By conducting the post-exposure baking, advantageous effects, such as improvement in post-development resolution or increase in the allowable range of development conditions, can be expected. The post-exposure baking can use an oven, a hot plate, infrared rays, a flash annealing device, a laser annealing device, or the like. The post-exposure baking temperature is preferably 50 to 180°C, and more preferably 60 to 150°C. The post-exposure baking time is preferably 10 seconds to several hours. When the post-exposure baking time is within the above range, a reaction progresses favorably, so that the development time can sometimes be reduced.

In the step (4), the exposed resin film is developed using a developer, whereby portions other than the exposed portions are removed. The developer is preferably a good solvent for the photosensitive resin composition or a combination of the good solvent and a poor solvent. For example, in the case of a photosensitive resin composition insoluble in an alkaline aqueous solution, NMP, N-cyclohexyl-2-pyrrolidone, DMAc, cyclopentanone, cyclohexanone, GBL, α-acetyl-γ-butyrolactone, and the like are preferable as the good solvent, and toluene, xylene, methanol, ethanol, isopropyl alcohol, ethyl lactate, propylene glycol methyl ether acetate, water, and the like are preferable as the poor solvent. When a good solvent and a poor solvent are mixed and used, it is preferable to adjust the ratio of the poor solvent to the good solvent according to the solubility of the polymer in the photosensitive resin composition. Two or more types of solvents, for example, several types of solvents may be used in combination. On the other hand, in the case of a photosensitive resin composition soluble in an alkaline aqueous solution, the developer to be used for development is one

that dissolves and removes a polymer soluble in the alkaline aqueous solution, and is typically an alkaline aqueous solution in which an alkali compound is dissolved. Examples of the alkali compound include tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, and hexamethylenediamine. In some cases, polar solvents such as NMP, DMF, DMAc, DMSO, GBL, and dimethylacrylamide, alcohols such as methanol, ethanol, and isopropanol, esters such as ethyl lactate and propylene glycol monomethyl ether acetate, and ketones such as cyclopentanone, cyclohexanone, isobutyl ketone, and methyl isobutyl ketone may be added alone or in combination of several solvents to the alkaline aqueous solution. As the developing method, a method of a spray mode, a paddle mode, a dip mode, an ultrasonic mode and the like can be employed.

Subsequently, the pattern formed by the development is preferably subjected to a rinsing treatment with deionized water. Here, alcohols such as ethanol and isopropyl alcohol, esters such as ethyl lactate and propylene glycol monomethyl ether acetate, or the like may be added to the deionized water for the rinsing treatment.

Next, the step (5) is conducted. By the heating treatment, a remaining solvent or a component having low heat resistance can be removed, and, therefore, the heat resistance, breaking elongation, and the chemical resistance of the cured film can be improved. When the resin composition of the present invention includes a polyimide resin, a polybenzoxazole resin and/or a copolymer resin of a structural unit of a polyimide resin and a structural unit of a polybenzoxazole resin, an imide ring and an oxazole ring can be formed by the heating treatment, and therefore the heat resistance, the breaking elongation, and the chemical resistance can be improved. Furthermore, when the resin composition includes a thermally crosslinking agent, a thermally crosslinking reaction can be made to proceed by the heating treatment, and the heat resistance and the chemical resistance can be improved. This heating treatment is conducted for 5 minutes to 5 hours while selecting temperature levels and increasing the temperature stepwise, or while selecting a certain temperature range and continuously increasing the temperature. As one example, the heating treatment is conducted at each of 150°C and 250°C for 30 minutes. Alternatively, examples thereof include a method of linearly increasing the temperature from room temperature up to 300°C over 2 hours. The heating treatment condition in the present invention is preferably 180°C or more, more preferably 200°C or more, still more preferably 230°C or more, and particularly preferably 240°C or more. The heating treatment condition is preferably 450°C or less, and more preferably 350°C or less.

Next, as an example of a method for producing the cured film of the present invention, a method for producing a cured film using a photosensitive sheet made of the resin composition of the present invention containing the component (E) being a photosensitive agent formed in a sheet shape will be described. Here, the photosensitive sheet refers to a sheet-shaped photosensitive resin composition obtained by applying the photosensitive resin composition onto a peelable substrate and drying the photosensitive resin composition.

In the case of using a photosensitive sheet made of the resin composition of the present invention formed in a sheet shape, when the photosensitive sheet has a protective film, the protective film is peeled off, the photosensitive sheet and the substrate are arranged to face each other, and the photosensitive sheet and the substrate are bonded to each other by thermocompression bonding, whereby a photosensitive resin film is obtained. The photosensitive sheet can be obtained by applying the resin composition of the present invention onto a support film composed of polyethylene terephthalate or the like, which is a peelable substrate, and drying the resin composition.

The thermocompression bonding can be conducted by a heat press treatment, a heat lamination treatment, a heat vacuum lamination treatment, or the like. The bonding temperature is preferably 40°C or more from the viewpoint of adhesion and embeddability to the substrate. In addition, to prevent the photosensitive sheet from being cured upon bonding and the resolution of pattern formation in exposure and development steps from deteriorating, the bonding temperature is preferably 140°C or less.

In the photosensitive resin film obtained by bonding the photosensitive sheet to the substrate, a cured film can be formed according to the step of exposing the resin film, the step of developing the exposed resin film, and the step of heat-curing.

The electronic component of the present invention includes the cured film of the present invention.

The cured film formed from the resin composition of the present invention can be used as an insulating film and a protective film constituting the electronic component.

Examples of the electronic component include active components having a semiconductor such as transistors, diodes, integrated circuits (ICs), and memories, as well as passive components such as resistors, capacitors, and inductors. Further, an electronic component including a semiconductor is also referred to as a semiconductor device or a semiconductor package.

Examples of the cured film in the electronic component are suitably used for uses such as a passivation film of a semiconductor, a semiconductor element, a surface protective film such as a thin film transistor (TFT), an interlayer insulating film such as an interlayer insulating film between redistributions in high-density multilayer wiring for mounting of 2 to 10 layers, an insulating film of a touch panel display, a protective film, and an insulation layer of an organic

electroluminescent element, but are not limited thereto, and can have various structures.

The electronic component of the present invention preferably has the cured film of the present invention on a substrate. The substrate surface on which the cured film is to be formed can be appropriately selected depending on applications and steps. Examples of the substrate include a silicon substrate, a silicon carbide substrate, a gallium nitride substrate, ceramics, gallium arsenide, metal, and an epoxy resin. The substrate is preferably a silicon substrate, a silicon carbide substrate, or a gallium nitride substrate.

The organic EL display device of the present invention includes the cured film of the present invention. Preferably, the organic EL display device of the present invention includes the cured film of the present invention as one or more selected from the group consisting of a pixel defining layer, an electrode insulation layer, a wiring insulation layer, an interlayer insulation layer, a TFT planarization layer, an electrode planarization layer, a wiring planarization layer, a TFT protective layer, an electrode protective layer, a wiring protective layer, a gate insulation layer, a color filter, a black matrix, and a black column spacer.

## EXAMPLES

The present invention will be described more concretely hereinafter with reference to examples and comparative example. However, the present invention is not limited to these embodiments. Of the compounds used, those whose abbreviations are used will be named below.

ODPA: 4,4'-oxydiphthalic anhydride
TDA-100: 1,3,3a,4,5,9b-hexahydro-5(tetrahydro-2,5-dioxo-3-furanyl)naphtho[1,2-c]furan-1,3-dione (manufactured by New Japan Chemical Co., Ltd.)
BAHF: 2,2-bis(3-amino-4-hydroxyphenyl)hexafluoropropane (manufactured by Central Glass Co., Ltd.)
BAP: 2,2-bis(3-amino-4-hydroxyphenyl)propane (manufactured by Wakayama Seika Kogyo Co., Ltd.)
SiDA: 1,3-bis(3-aminopropyl)tetramethyldisiloxane
OBBOC: 4,4'-oxybisbenzoyl chloride (manufactured by Iharanikkei Chemical Industry Co., Ltd.)
MAP: 3-aminophenol (manufactured by Tokyo Chemical Industry Co., Ltd.)
NA: 5-norbornene-2,3-dicarboxylic anhydride
OAP: 2-aminophenol (manufactured by Tokyo Chemical Industry Co., Ltd.)
MAOC: methacryloyl chloride (manufactured by Tokyo Chemical Industry Co., Ltd.)
MPA: 3-methoxy-N,N-dimethylpropanamide (manufactured by KJ Chemicals Corporation)
DMIB: N,N-dimethylisobutyramide
DMPA: N,N-dimethylpropionamide
NMP: N-methyl-2-pyrrolidone
PGME: propylene glycol monomethyl ether
GBL: γ-butyrolactone
CHN: cyclohexanone
HEMA: 2-hydroxyethyl methacrylate
ITO: indium tin oxide
TMAH: tetramethylammonium hydroxide
DMFDMA: N,N-dimethylformamide dimethyl acetal
BPAF: bisphenol AF

### [Common treatment conditions]

In the following measurement and evaluation methods and Examples and Comparative Examples, the following treatments were conducted under the following conditions unless otherwise specified.

### (1) Pretreatment of ITO substrate

A glass substrate with a 100 nm-thick ITO film formed on glass by sputtering (manufactured by GEOMATEC Co., Ltd.; hereinafter referred to as "ITO substrate") was subjected to an ozone cleaning treatment for 100 seconds with a tabletop photo surface processor (PL16-110; manufactured by SEN LIGHTS Corporation), and then used. A Si wafer (manufactured by Electronics and Materials Corporation) was subjected to dehydration baking by heating at 130°C for 2 minutes with a hot plate HP-1SA (manufactured by AS ONE Corporation), and then was used.

(2) Heat treatment (curing)

A developed film was heated at 250°C for 1 hour in a nitrogen atmosphere with a high-temperature inert gas oven INH-9CD-S (manufactured by Koyo Thermo Systems Co., Ltd.), affording a cured film.

[Measurement and evaluation methods]

(1) Weight average molecular weight of component (A)

The weight average molecular weight (Mw) of the resin or the resin solution obtained in each Synthesis Example was determined by measuring the polystyrene-equivalent weight average molecular weight (Mw) under the following conditions using a GPC analyzer.

Measurement device: Waters 2695 (manufactured by Waters Corporation)
Column temperature: 50°C
Flow rate: 0.4 mL/min
Detector: 2489 UV/Vis Detector (measurement wavelength: 260 nm)
Eluent: NMP (containing 0.21 mass% of lithium chloride and 0.48 mass% of phosphoric acid)
Guard column: TOSOH TSK guard column (manufactured by Tosoh Corporation)
Column: Tandem of TOSOH TSK-GEL a-2500 and TOSOH TSK-GEL a-4000 (both manufactured by Tosoh Corporation)
Number of measurements: twice (the average value of the measurements was taken as the weight average molecular weight of the polyimide).

(2) Esterification rate

$^1$H-NMR of a mixed solution of 10 mg of the polyamic acid ester obtained in each Synthesis Example and 0.8 g of deuterated DMSO (DMSO-d6) was measured using a nuclear magnetic resonance (NMR) spectrometer EX-270 (manufactured by JEOL Ltd.), and the integrated value of the peaks derived from aromatic protons of the resin was determined. The esterification rate of the polyamic acid ester was calculated from the area ratio between the peak derived from methyl proton of the carboxylic acid ester and the peak derived from the ethylenically unsaturated double bond group. Since resins other than the polyamic acid ester do not have a carboxylic acid ester, the esterification rate is indicated by "-" as being unmeasurable.

(3) Imide ring closure rate ($R_{IM}$ (%))

The polyimide resin obtained in each Synthesis Example was dissolved in GBL such that a concentration of 35 mass% was attained. This solution was applied onto a 4 inch silicon wafer by a spin coating method using a spin coater 1H-DX (manufactured by Mikasa Co., Ltd.), and then baked on a hot plate at 120°C for 3 minutes, whereby a resin film having a thickness of 4 to 5 μm was prepared. The wafer with the resin film was divided into two halves, and one was cured under a nitrogen stream (oxygen concentration: 20 ppm or less) at 140°C for 30 minutes using a clean oven CLH-21CD-S (manufactured by Koyo Thermo Systems Co., Ltd.), and then at 320°C for 1 hour following raising of the temperature. Thus, an imide ring was completely closed. The transmitted infrared absorption spectra of the resin film before and after the curing were measured with an infrared spectrophotometer FT-720 (manufactured by HORIBA, Ltd.). The presence of absorption peaks of the imide structure attributable to a polyimide (around 1780 $cm^{-1}$ and around 1377 $cm^{-1}$) was confirmed, and the peak intensities around 1377 $cm^{-1}$ (before curing: S, after curing: T) were determined. The peak intensity ratio obtained by dividing the peak intensity (S) by the peak intensity (T) was calculated by the following equation, and defined as the content of imide groups in the polymer before heat treatment, that is, the imide ring closure rate.

$$R_{IM}\ (\%) = (S/T) \times 100$$

Since resins other than the polyimide (including the polyamic acid ester) do not have a structural unit of the polyimide, the imide ring closure rate is indicated by "-" as being unmeasurable.

(4) Evaluation of contents of compounds represented by formulas (1) and (2) based on component (A)

0.03 g of the component (A) obtained in each Synthesis Example or 0.1 g of a solution of the component (A) obtained in a Synthesis Example, and 0.01 g of methyl 3-nitrobenzoate as an internal standard substance were dissolved

in 0.7 g of deuterated DMSO, and analyzed with an NMR spectrometer GX-270 (manufactured by JEOL Ltd.). Based on the area of the peak around 3.9 ppm derived from methyl 3-nitrobenzoate, the contents [parts by mass] of the compounds represented by the formulas (1) and (2) based on 100 parts by mass of the component (A) were measured from each peak area.

(5) Measurement of film thickness

With the use of a surface roughness and contour measuring instrument (SURFCOM 1400D; manufactured by Tokyo Seimitsu Co., Ltd.), at the measurement magnification of 10,000 times, the measurement length of 1.0 mm, the measurement speed of 0.30 mm/s, the film thickness was measured.

(6) Sensitivity evaluation

The photosensitive resin composition obtained in each of Examples 18 to 24 and Comparative Examples 4 and 5 was applied onto a 100 mm × 100 mm ITO substrate by spin coating using a spin coater MS-A100 (manufactured by Mikasa Co., Ltd.) with the rotation speed adjusted such that the film thickness of a prebaked film was about 1.8 μm, and then prebaked at 110°C for 120 seconds using BUZZER HOTPLATE HPD-3000BZN (manufactured by AS ONE Corporation), whereby a prebaked film having a film thickness of about 1.8 μm was prepared. The resulting prebaked film was exposed to ultraviolet rays with a maximum exposure energy of 150 $mJ/cm^2$ (i-ray illuminometer value) through a positive mask (manufactured by HOYA Corporation, stripe design line width: 20 μm) using a manually operated exposure machine MA-1200 (manufactured by Japan Science Engineering Co., Ltd.) with the exposure energy reduced every 5 $mJ/cm^2$, developed, rinsed, and dried, affording a patterned substrate having a photosensitive resin film formed in a prescribed pattern. The sensitivity and the development residue were evaluated using the patterned substrate of each exposure energy. The development was conducted by a method of performing shower development with an alkaline developer, namely, a 2.38 mass% aqueous TMAH solution using a portable automatic developer for photolithography AD-2000 (manufactured by Takizawa Sangyo Co., Ltd.). The development time was adjusted as follows.

Positive photosensitive resin compositions (Examples 18 to 21, Comparative Example 4): The development time was adjusted such that the amount of film loss of an unexposed portion was 0.5 μm, and rinsing was conducted using deionized water.

Negative photosensitive resin compositions (Examples 22 to 24, Comparative Example 5): The prepared prebaked film was subjected to spray development with a 2.38 mass% aqueous TMAH solution using a portable developer for photolithography AD-2000 (manufactured by Takizawa Sangyo Co., Ltd.), and the time taken until the prebaked film (unexposed portion) was completely dissolved (breaking point, hereinafter B.P.) was measured. The time being 1.5 times B.P. was determined as the development time, and rinsing was conducted using deionized water.

The opening portion of the resulting developed film was observed with an FPD/LSI inspection microscope OPTIPHOT-300 (manufactured by Nikon Corporation), and the minimum exposure energy at which the opening width was the line width (20 μm) which was equal to that in the mask design was defined as sensitivity. It was determined as follows, and A, B, and C with the sensitivity of less than 110 $mJ/cm^2$ were regarded as acceptable. A is the most preferable result.

A: The sensitivity is less than 80 $mJ/cm^2$.
B: The sensitivity is 80 $mJ/cm^2$ or more and less than 95 $mJ/cm^2$.
C: The sensitivity is 95 $mJ/cm^2$ or more and less than 110 $mJ/cm^2$.
D: The sensitivity is 110 $mJ/cm^2$ or more.

(7) Evaluation of chemical resistance

The resin composition obtained in each of Examples and Comparative Examples was applied onto a non-alkali glass plate OA-10 (manufactured by Nippon Electric Glass Co., Ltd.) at an arbitrary rotation speed by a spin coating method, affording a resin film, which was then prebaked on a hot plate at 120°C for 2 minutes as a drying step, affording a resin film. The substrate with the resin film was heated at 250°C for 1 hour in a nitrogen atmosphere with a high-temperature inert gas oven INH-9CD-S (manufactured by Koyo Thermo Systems Co., Ltd.), affording a cured film having a film thickness of 2.0 μm. Thereafter, the cured film was immersed in a peeling liquid 106 (manufactured by Tokyo Ohka Kogyo Co., Ltd.) at 40°C for 5 minutes, the film thickness before and after the treatment was measured, and the amount of film loss by the immersion treatment was determined. It was determined as follows, and A, B, and C with the amount of film loss of less than 0.10 μm were regarded as acceptable.

A: The amount of film loss is less than 0.03 μm.
B: The amount of film loss is 0.03 μm or more and less than 0.06 μm.

C: The amount of film loss is 0.06 μm or more and less than 0.10 μm.
D: The amount of film loss is 0.10 μm or more.

(8) Evaluation of flatness

A sectional view of a flatness evaluation sample is shown in Fig. 1. Using a spin coater MS-A100 (manufactured by Mikasa Co., Ltd.), a resin composition as a sample was applied by a spin coating method onto a 100 mm-square stepped substrate 1 in which five line patterns each having a thickness (height) of 1.2 μm, a width of 5 μm, and a length of 15 mm were patterned in parallel at an interval of 5 μm in the central portion of the substrate, and prebaked at 110°C for 120 seconds to prepare a prebaked film such that the film thickness h0 was 3.7 μm in a flat portion (the place where the measurement was conducted is referred to as "measurement point A" for convenience) not provided with the pattern on the substrate, which was separated to an extent not affected by the patterns. Subsequently, the resulting substrate with the film was subjected to a curing step in which the temperature was raised to 250°C at 5°C/min at an oxygen concentration of 20 ppm or less and a heating treatment was conducted at 250°C for 1 hour using a high-temperature inert gas oven INH-9CD-S (manufactured by Koyo Thermo Systems Co., Ltd.) to prepare a cured film having a film thickness of about 2.5 μm at the measurement point A. The surface step of the resulting cured film was measured with a surface profiler P-15 (manufactured by KLA-Tencor Corporation). For three line patterns among the five line patterns excluding the outermost two line patterns, the average value of the heights h1 to h3 of the line patterns from the baseline 10 of the film present on the line patterns was taken as the surface step h. Note that the baseline 10 was defined as a line connecting points at which the film thicknesses of the recesses present on the left and right sides of each of the portions of the resin film in the mountain range shape for measuring h1 to h3 were the smallest as viewed from Fig. 1. A specific example is described below. In Fig. 1, a straight line connecting the bottom portions a1 and a2 of the step shape was defined as a baseline, and a length from the top portion b1 of the step shape to an intersection of a line drawn perpendicularly to the substrate surface and the baseline was defined as h1. As to h2, a line connecting a2 and a3 was defined as a baseline, and h2 was defined as a length from b2 to an intersection of a line drawn from b2 perpendicularly to the substrate surface and the baseline. As to h3, a line connecting a3 and a4 was defined as a baseline, and h3 was defined as a length distance from b3 to an intersection of a line drawn from b3 perpendicularly to the substrate surface and the baseline. Flatness was determined from the surface step h as follows, and A, B, and C with the surface step h of less than 0.4 μm were regarded as acceptable. A is the most preferable result.

A: The surface step h is less than 0.2 μm.
B: The surface step h is 0.2 μm or more and less than 0.3 μm.
C: The surface step h is 0.3 μm or more and less than 0.4 μm.
D: The surface step h is 0.4 μm or more.

(9) Evaluation of breaking elongation

The resin composition obtained in each of Examples and Comparative Examples was applied onto an 8-inch silicon wafer by a spin coating method using a coater/developer ACT-8 and prebaked at 120°C for 3 minutes in such a manner that the film thickness was 15 μm after the prebaking. Then, using an inert oven CLH-21CD-S (manufactured by Koyo Thermo Systems Co., Ltd.), the temperature of the prebaked item was raised to 250°C at a rate of 4.0°C/min at an oxygen concentration of 20 ppm or less, followed by a heating treatment at 250 °C for 1 hour. When the temperature reached 50°C or less, the silicon wafer was taken out and immersed in 45 mass% of hydrofluoric acid for 5 minutes to peel off the cured film of the resin composition from the wafer. This film was cut into a strip having a width of 1 cm and a length of 9 cm, and pulled at a pulling speed of 50 mm/min at a room temperature of 23.0°C and a humidity of 45.0% RH using Tensilon RTM-100 (manufactured by Orientec Corporation) to measure the breaking elongation. The measurement was performed on 10 strips per sample, and the average of the top five measured values ranked in descending order was determined from the results. It was determined as follows, and AA, A, B, and C with the value of breaking elongation of 15% or more were regarded as acceptable.

AA: The value of breaking elongation is 60% or more.
A: The value of breaking elongation is 45% or more and less than 60%.
B: The value of breaking elongation is 30% or more and less than 45%.
C: The value of breaking elongation is 15% or more and less than 30%.
D: The value of breaking elongation is less than 15%.

(10) Test of adhesion after pressure cooker test (PCT) treatment

A test of adhesion with a metal material was conducted by the following method.

Copper was sputtered on a silicon wafer to prepare a substrate (copper-sputtered substrate) having a metal material layer formed in a thickness of 200 nm on the surface. On this substrate, the resin composition obtained in each of Examples and Comparative Examples was applied and heat-treated in the same manner as in (9), affording a cured film.

A grid pattern of 10 rows and 10 columns was cut on the heat-treated film at intervals of 2 mm using a single-edged blade. Next, using a pressure cooker test (PCT) apparatus HAST CHAMBER EHS-212MD (manufactured by ESPEC CORP.), a PCT treatment was conducted at saturation conditions of 121°C and 2 atm for 400 hours and 800 hours, and then how many squares were peeled out of 100 squares by peeling with "CELLOTAPE" (registered trademark in Japan) was counted, and the adhesion characteristic between the metal material and the resin cured film was evaluated. It was determined as follows, and A, B, and C with the number of peeled pieces in the peeling test of less than 20 were regarded as acceptable.

A: The number of peeled pieces is 0.
B: The number of peeled pieces is 1 or more and less than 10.
C: The number of peeled pieces is 11 or more and less than 20.
D: The number of peeled pieces is 21 or more.

(11) Evaluation of light emission reliability of organic EL display device

The organic EL display device obtained in each of Examples 18 to 24 and Comparative Examples 4 and 5 was placed on a hot plate heated to 80°C with the display unit (light-emitting surface) facing upward, and after 1 hour from when the organic EL display device was caused to emit light by DC drive at 10 mA/$cm^2$, the pixel light-emitting area ratio (area ratio of the light-emitting portions to the area of the light-emitting pixels) was evaluated, and then the power was temporarily turned off, whereby the display device was turned off. Subsequently, the display unit was continuously irradiated with light having an illuminance of 3.0 W/$m^2$ at a wavelength of 420 nm using a xenon lamp as a light source as pseudo sunlight. After 100 hours and 500 hours from the start of irradiation, the display device was caused to emit light again, the pixel light-emitting area ratio was measured for 10 light-emitting pixel portions located in the central portion, and the average value thereof was calculated. Taking the pixel light-emitting area ratio after 1 hour as a standard, it was determined that the higher the pixel light-emitting area ratio is maintained, the better the light emission reliability is, and evaluation was conducted on the basis of the following determination criteria. A to C with the area ratio of the light-emitting portions to the area of the light-emitting pixels or 65% or more were determined to be acceptable, and D was determined to be unacceptable.

A: The area ratio of the light-emitting portions to the area of the light-emitting pixels is 95% or more.
B: The area ratio of the light-emitting portions to the area of the light-emitting pixels is 80% or more and less than 95%.
C: The area ratio of the light-emitting portions to the area of the light-emitting pixels is 65% or more and less than 80%.
D: The area ratio of the light-emitting portions to the area of the light-emitting pixels is less than 65%.

<Synthesis Example 1: Synthesis of quinone diazide compound QD-a>

Under a dried nitrogen stream, 21.22 g (0.05 mol) of TrisP-PA (manufactured by Honshu Chemical Industry Co., Ltd.) and 36.27 g (0.135 mol) of 5-naphthoquinone diazide sulfonyl chloride were dissolved in 450 g of 1,4-dioxane, and the temperature of the resulting solution was adjusted to room temperature. A solution obtained by dissolving 15.18 g of triethylamine in 50 g of 1,4-dioxane was added dropwise thereto such that the temperature in the system was 35°C or less. After the dropwise addition, the solution was stirred at 30°C for 2 hours. The triethylamine salt was removed by filtration, and the filtrate was poured into water. Thereafter, filtration was conducted, and the generated precipitate was collected. The precipitate was dried in a vacuum dryer, affording a quinone diazide compound QD-a represented by formula (13).

[Chemical Formula 13]

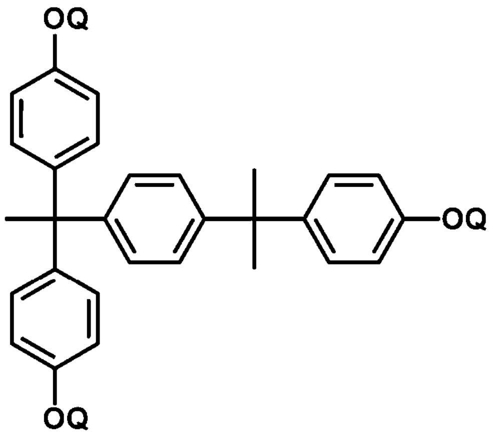

Q= 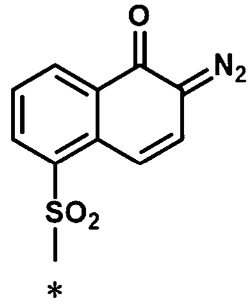 : H

(13)

9 : 1

In the formula (13), * represents a bonding site to an oxygen atom.

<Synthesis Example 2: Synthesis of quinone diazide compound QD-b>

A quinone diazide compound QD-b represented by formula (14) was obtained by conducting synthesis in the same manner as in the Synthesis Example of the quinone diazide compound QD-a except that 36.27 g (0.135 mol) of 4-naphthoquinone diazide_'sulfonyl' chloride was used instead of 36.27 g (0.135 mol) of 5-naphthoquinone diazide sulfonyl chloride.

[Chemical Formula 14]

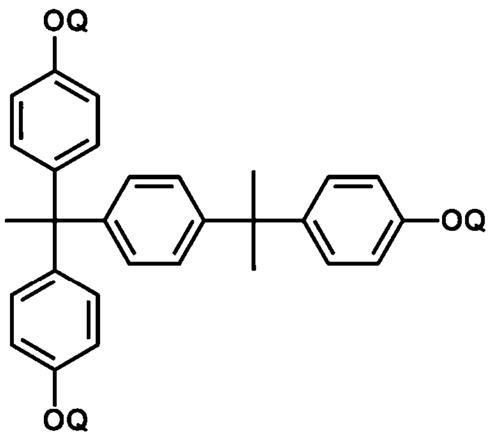

Q= 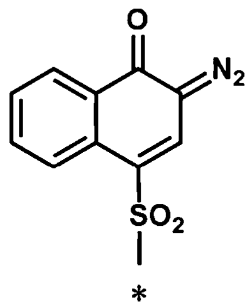 : H

(14)

9 : 1

In the formula (14), * represents a bonding site to an oxygen atom.

<Synthesis Example 3: Synthesis of 2,2-bis[3-(3-aminobenzamide)-4-hydroxyphenyl]hexafluoropropane (HA)>

BAHF (18.3 g (0.05 mol)) was dissolved in 100 mL of acetone and 17.4 g (0.3 mol) of propylene oxide (manufactured by Tokyo Chemical Industry Co., Ltd.), and the solution was cooled to -15°C. To this solution, a solution prepared by dissolving 20.4 g (0.11 mol) of 3-nitrobenzoyl chloride (manufactured by Tokyo Chemical Industry Co., Ltd.) in 100 mL of acetone was added dropwise. After the completion of the dropwise addition, the solution was stirred at -15°C for

4 hours and then returned to room temperature. The precipitated white solid was collected by filtration, and vacuum-dried at 50°C.

30 g of the obtained white solid was charged in a 300 mL stainless steel autoclave, and dispersed in 250 mL of methyl cellosolve, followed by adding 2.0 g of 5% palladium on carbon (manufactured by Wako Pure Chemical Industries, Ltd.). Hydrogen was introduced thereinto with a balloon, and a reduction reaction was conducted at room temperature. After about 2 hours, the reaction was terminated when it was confirmed that the balloon did not deflate any more. After the termination of the reaction, the palladium compound as the catalyst was removed by filtration, followed by concentration with a rotary evaporator, affording a hydroxyl group-containing diamine compound (HA) represented by the following formula.

[Chemical Formula 15]

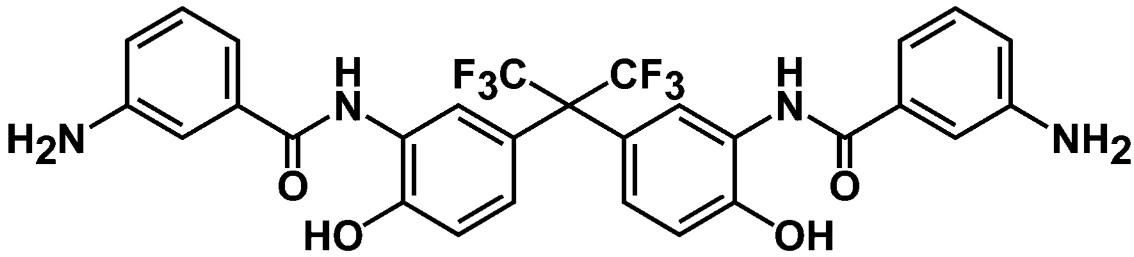

<Synthesis Example 21: Synthesis of diamine (DAP-B)>

26.70 g (0.086 mol) of BisP-HTG (manufactured by Honshu Chemical Industry Co., Ltd.; 4,4'-(3,3,5-trimethylcyclohexylidene)bisphenol)) and 100 mL of glacial acetic acid were charged into a 500-mL four-necked flask equipped with a stirrer, a thermocouple and a dropping funnel, and stirred, and the internal temperature was raised to 50°C in a hot water bath. 2 mL (0.026 mol) of concentrated nitric acid was added dropwise thereto over 1 hour, and thereafter, the internal temperature was lowered to 13°C by ice cooling, and 13.3 mL (0.149 mol) of concentrated nitric acid was further added dropwise over 1 hour. Thereafter, stirring was continued for 3 hours, and the precipitated yellow crystals were collected by filtration, washed sequentially with 40 mL of glacial acetic acid and 80 mL of deionized water, and dried under reduced pressure, affording a dinitro form.

Subsequently, 54.06 g (0.135 mol) of the dinitro form, 180 mL (3.71 mol) of hydrazine monohydrate and 900 mL of ethanol were put in a 2-L four-necked flask equipped with a stirrer, a thermocouple, a Dimroth cooling tube and a dropping funnel, and stirred under ice cooling, and 0.9 g of 5% palladium on carbon (manufactured by Wako Pure Chemical Industries, Ltd.) suspended in 30 mL of ethanol was added dropwise thereto over 1 hour. Thereafter, the solution was refluxed for 2 hours, and the palladium on carbon was removed by filtration while washing with 300 mL of ethanol. All of the solvent was removed by heating under reduced pressure conditions. The residue was cleaned with 75 mL of ethanol cooled with ice and collected by filtration, then further washed sequentially with 75 mL of deionized water and 150 mL of diethyl ether, and dried under reduced pressure, affording a diamine (DAP-B) represented by the following formula.

[Chemical Formula 16]

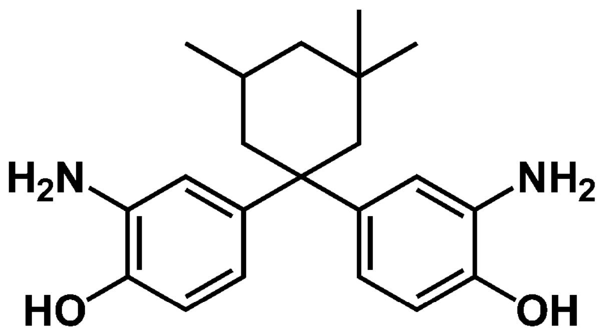

<Synthesis Example 22: Synthesis of diamine (HC)>

A diamine (HC) represented by the following formula was obtained in the same manner as in Synthesis Example

3 except that 17.0 g (0.05 mol) of DAP-B obtained in Synthesis Example 21 was used instead of BAHF.

[Chemical Formula 17]

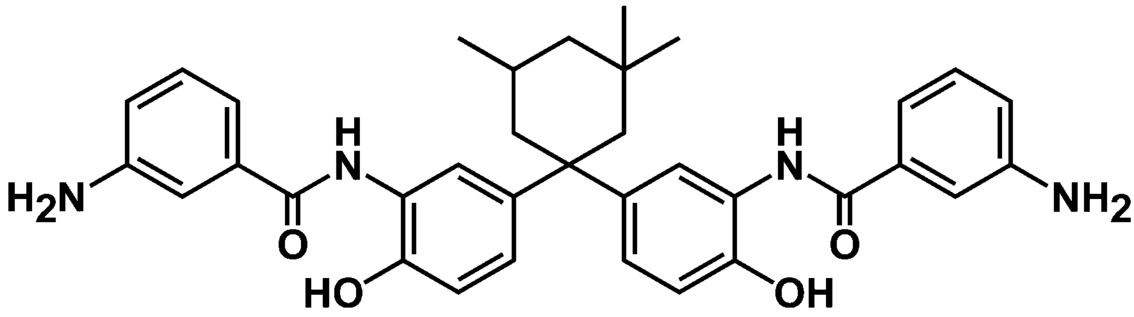

<Synthesis Example 4: Synthesis of polyimide (a-1)>

Under a dry nitrogen stream, 21.3 g (0.058 mol) of BAHF, 0.86 g (0.0034 mol) of SiDA, and 1.50 g (0.014 mol) of MAP as an end-capping agent were dissolved in 150 g of MPA. To this solution, 21.4 g (0.069 mol) of ODPA was added together with 30 g of MPA, and the resulting mixture was allowed to react at 60°C for 1 hour, and then stirred at 180°C for 4 hours. After the termination of the stirring, the solution was poured into 3 L of deionized water, affording a white precipitate. The precipitate was collected by filtration, washed three times with deionized water, and then dried for 20 hours in a vacuum dryer at 80°C, affording a powder of a polyimide (a-1).

<Synthesis Example 5: Synthesis of polyimide (a-2)>

Under a dry nitrogen stream, 19.6 g (0.054 mol) of BAHF, 3.95 g (0.015 mol) of BAP, and 1.67 g (0.015 mol) of MAP as an end-capping agent were dissolved in 150 g of MPA. To this solution, 18.98 g (0.061 mol) of TDA-100 and 4.74 g (0.015 mol) of ODPA were added together with 30 g of MPA, and the resulting mixture was allowed to react at 60°C for 1 hour, and then stirred at 180°C for 4 hours. After the termination of the stirring, the solution was poured into 3 L of deionized water, affording a white precipitate. The precipitate was collected by filtration, washed three times with deionized water, and then dried for 20 hours in a vacuum dryer at 80°C, affording a powder of a polyimide (a-2).

<Synthesis Example 18: Synthesis of polyimide (a-15)>

A powder of a polyimide (a-15) was obtained in the same manner as in Synthesis Example 4 except that 19.8 g (0.058 mol) of the diamine (DAP-B) obtained in Synthesis Example 21 was used instead of 21.3 g (0.058 mol) of BAHF.

<Synthesis Example 6: Synthesis of polyamic acid ester (a-3)>

In a dry nitrogen stream, 22.0 g (0.037 mol) of the hydroxyl group-containing diamine (HA) obtained in Synthesis Example 3 and 0.54 g (0.0022 mol) of SiDA were dissolved in 100 g of MPA. To this solution, 13.4 g (0.043 mol) of ODPA was added together with 20 g of MPA, and the resulting mixture was stirred at 40°C for 2 hours. Then, 0.95 g (0.0087 mol) of MAP as an end-capping agent was added together with 20 g of MPA, and the resulting mixture was allowed to react at 40°C for 1 hour. Thereafter, a solution prepared by diluting 10.3 g (0.087 mol) of DMFDMA with 10 g of MPA was added dropwise. After the dropwise addition, stirring was continued at 40°C for 2 hours. After the termination of the stirring, the solution was poured into 2 L of deionized water, and a precipitate of a polymer solid was collected by filtration. Further, the precipitates were washed with 2 L of deionized water three times, and the collected polymer solid was dried in a vacuum dryer at 50°C for 72 hours, affording a polyamic acid ester (a-3) as a form of polyimide.

<Synthesis Example 7: Synthesis of polyamic acid ester (a-4)>

A polyamic acid ester (a-4) as a form of polyimide was obtained in the same manner as in Synthesis Example 6 except that the solution was poured into 3 L of deionized water, a precipitate of a polymer solid was collected by filtration, and washing was further conducted with 3 L of deionized water six times.

<Synthesis Example 8: Synthesis of polyamic acid ester (a-5)>

A 2-liter separatory flask was charged with 24.8 g (0.080 mol) of ODPA, and 20.8 g (0.16 mol) of HEMA and 310 g of MPA were added thereto. While stirring the mixture at room temperature, 12.7 g (0.16 mol) of pyridine was added thereto, affording a reaction mixture (ODPA-HEMA). After completion of heat generation due to the reaction, the reaction mixture was allowed to cool to room temperature, and then left at rest for 16 hours.

Next, under ice cooling, a solution prepared by dissolving 28.9 g (0.14 mol) of DCC in 180 g of MPA was added to the reaction mixture over 40 minutes while stirring. Subsequently, a suspension prepared by suspending 82.2 g (0.14 mol) of HA and 1.99 g (0.008 mol) of SiDA in 230 g of MPA was added over 60 minutes while stirring. Further, after stirring at room temperature for 2 hours, 24.8 g (0.080 mol) of ODPA was added, and stirring was continued at room temperature for 3 hours, then 3.49 g (0.032 mol) of MAP was added. Stirring was continued at room temperature for 1 hour, then the precipitate generated in the reaction mixture was removed by filtration, and a reaction liquid was obtained.

The reaction solution was poured into 3 L of deionized water, affording a white precipitate. This precipitate was collected by filtration, washed twice with deionized water, then washed once with isopropanol, and then dried in a vacuum dryer at 50°C for 72 hours, affording a polyamic acid ester (a-5) as a form of polyimide.

<Synthesis Example 9: Synthesis of polyamic acid ester (a-6)>

A polyamic acid ester (a-6) as a form of polyimide was obtained in the same manner as in Synthesis Example 6 except that DMIB was used instead of MPA.

<Synthesis Example 10: Synthesis of polyamic acid ester (a-7)>

A polyamic acid ester (a-7) as a form of polyimide was obtained in the same manner as in Synthesis Example 6 except that DMPA was used instead of MPA.

<Synthesis Example 11: Synthesis of polyamic acid (a-8)>

In a dry nitrogen stream, 22.0 g (0.037 mol) of the hydroxyl group-containing diamine (HA) obtained in Synthesis Example 3 and 0.54 g (0.0022 mol) of SiDA were dissolved in 100 g of MPA. To this solution, 13.4 g (0.043 mol) of ODPA was added together with 20 g of MPA, and the resulting mixture was stirred at 40°C for 2 hours. Then, 0.95 g (0.0087 mol) of MAP as an end-capping agent was added together with 20 g of MPA, and stirring was continued at 60°C for 2 hours. After the termination of the stirring, the solution was poured into 2 L of deionized water, and a precipitate of a polymer solid was collected by filtration. Further, the precipitates were washed with 2 L of deionized water three times, and the collected polymer solid was dried in a vacuum dryer at 50°C for 72 hours, affording a polyamic acid (a-8) as a form of polyimide.

<Synthesis Example 12: Synthesis of polyamic acid ester (a-9)>

A polyamic acid ester (a-9) as a form of polyimide was obtained in the same manner as in Synthesis Example 6 except that NMP was used instead of MPA.

<Synthesis Example 13: Synthesis of polyamic acid ester (a-10)>

A polyamic acid ester (a-10) as a form of polyimide was obtained in the same manner as in Synthesis Example 6 except that GBL was used instead of MPA.

<Synthesis Example 19: Synthesis of polyamic acid ester (a-16)>

A polyamic acid ester (a-16) as a form of polyimide was obtained in the same manner as in Synthesis Example 6 except that 21.2 g (0.037 mol) of the diamine (HC) obtained in Synthesis Example 22 was used instead of 22.0 g (0.037 mol) of the hydroxyl group-containing diamine (HA).

<Synthesis Example 20: Synthesis of polyamic acid ester (a-17)>

A polyamic acid ester (a-17) as a form of polyimide was obtained in the same manner as in Synthesis Example 7 except that 21.2 g (0.037 mol) of the diamine (HC) obtained in Synthesis Example 22 was used instead of 22.0 g (0.037 mol) of the hydroxyl group-containing diamine (HA).

<Synthesis Example 14: Synthesis of polyhydroxyamide (a-11)>

Under a dry nitrogen stream, 33.0 g (0.090 mol) of BAHF was dissolved in 115 g of MPA. To this solution, 4.43 g (0.027 mol) of NA was added together with 15 g of MPA, and the resulting mixture was stirred at 85°C for 2 hours. After stirring, the solution was cooled to -15°C. A solution prepared by dissolving 22.6 g (0.077 mol) of OBBOC in 50 g of MPA was added dropwise thereto such that the internal temperature did not exceed 0°C. After the completion of the dropwise addition, stirring was continued at -15°C for 60 minutes, and then stirring was conducted at room temperature for 120 minutes. After the termination of the reaction, the solution was poured into 2 L of deionized water, and a white precipitate was collected. This precipitate was collected by filtration, washed with deionized water three times, and then dried in a vacuum dryer at 80°C for 24 hours, affording a polyhydroxyamide (a-11) as a form of polybenzoxazole resin.

<Synthesis Example 15: Synthesis of polyhydroxyamide (a-12)>

In a dry nitrogen stream, 29.2 g (0.80 mol) of BAHF and 3.07g (0.028 mol) of OAP were dissolved in 120 g of MPA, and the temperature of the solution was lowered to - 15°C. A solution prepared by dissolving 27.7 g (0.094 mol) of OBBOC in 60 g of MPA was added dropwise thereto such that the internal temperature did not exceed 0°C. After the completion of the dropwise addition, stirring was continued at -15°C for 60 minutes, and stirring was conducted at room temperature for 120 minutes. After the termination of the reaction, the solution was poured into 3 L of deionized water, and a white precipitate was collected. This precipitate was collected by filtration, washed with deionized water three times, and then dried in a vacuum dryer at 80°C for 24 hours, affording a polyhydroxyamide (a-12) as a form of polybenzoxazole resin.

<Synthesis Example 16: Synthesis of polyhydroxyamide (a-13)>

In a dry nitrogen stream, 28.7 g (0.11 mol) of BAP was dissolved in 100 g of MPA, and the temperature of the solution was lowered to -15°C. A solution prepared by dissolving 27.9 g (0.094 mol) of OBBOC in 50 g of MPA was added dropwise thereto such that the internal temperature did not exceed 0°C. After the completion of the dropwise addition, stirring was continued at -15°C for 30 minutes. Subsequently, a solution prepared by dissolving 3.48 g (0.033 mol) of MAOC in 30 g of MPA was added dropwise thereto such that the internal temperature did not exceed 0°C. After the completion of the dropwise addition, stirring was continued at -15°C for 60 minutes, and stirring was conducted at room temperature for 120 minutes. After the termination of the reaction, the solution was poured into 3 L of deionized water, and a white precipitate was collected. This precipitate was collected by filtration, washed with deionized water three times, and then dried in a vacuum dryer at 80°C for 24 hours, affording a polyhydroxyamide (a-13) as a form of polybenzoxazole resin.

<Synthesis Example 17: Synthesis of phenol resin (a-14)>

A phenol resin (a-14) of Synthesis Example 17 was synthesized by the method described in Synthesis Example 5 in paragraph [0120] of International Publication No. 2012/141165.

In Table 1, the measurement results of the constituents (molar ratio), the molecular weight (Mw), the esterification rate [%], and the contents [parts by mass] of the compounds represented by the formulas (1) and (2) in Synthesis Examples 4 to 16 and 18 to 20 are shown.

[Table 1]

| | Component (A) | Tetracarboxylic acid, dicarboxylic acid, and derivatives thereof (molar ratio) | | Diamine and derivatives thereof (molar ratio) | | End-capping agent (molar ratio) | Polymerization solvent | Resin evaluation | | | |
|---|---|---|---|---|---|---|---|---|---|---|---|
| | | | | | | | | Weight average molecular weight (Mw) | Esterification rate [%] | Tmidization rate [%] | Content of compounds represented by formula (1) and formula (2) [parts by mass] |
| Synthesis Example 4 | Polyimide (a-1) | ODPA (100) | - | BAHF (85) | SiDA (5) | MAP (20) | MPA | 25000 | - | 97 | 4.2 |
| Synthesis Example 5 | Polyimide (a-2) | TDA-100 (80) | ODPA (20) | BAHF (70) | BAP (20) | MAP (20) | MPA | 25000 | - | 98 | 4.7 |
| Synthesis Example 6 | Polyamic acid ester (a-3) | ODPA (100) | - | HA (85) | SiDA (5) | MAP (20) | MPA | 33000 | 70 | 5.0 | 4.2 |
| Synthesis Example 7 | Polyamic acid (a-4) | ODPA (100) | - | HA (85) | SiDA (5) | MAP (20) | MPA | 33000 | 72 | 4.8 | 1.1 |
| Synthesis Example 8 | Polyamic acid ester (a-5) | ODPA-HEMA (50) | ODPA (50) | HA (85) | SiDA (5) | MAP (20) | MPA | 25000 | 40 | 2.5 | 4.8 |
| Synthesis Example 9 | Polyamic acid ester (a-6) | ODPA (100) | - | HA (85) | SiDA (5) | MAP (20) | DMIB | 34000 | 65 | 6.2 | 5.2 |
| Synthesis Example 10 | Polyamic acid ester (a-7) | ODPA (100) | - | HA (85) | SiDA (5) | MAP (20) | DMPA | 30000 | 65 | 5.8 | 4.7 |
| Synthesis Example 11 | Polyamic acid (a-8) | ODPA (100) | - | HA (85) | SiDA (5) | MAP (20) | MPA | 33000 | - | 3.5 | 4.3 |
| synthesis Example 12 | Polyamic acid ester (a-9) | ODPA (100) | - | HA(85) | SiDA (5) | MAP (20) | NMP | 33000 | 72 | 5.1 | - |

(continued)

| | Component (A) | Tetracarboxylic acid, dicarboxylic acid, and derivatives thereof (molar ratio) | | Diamine and derivatives thereof (molar ratio) | | End-capping agent (molar ratio) | Polymerization solvent | Resin evaluation | | | |
|---|---|---|---|---|---|---|---|---|---|---|---|
| | | | | | | | | Weight average molecular weight (Mw) | Esterification rate [%] | Tmidization rate [%] | Content of compounds represented by formula (1) and formula (2) [parts by mass] |
| Synthesis Example 13 | Polyamic acid ester (a-10) | ONPA (100) | - | HA (85) | SiDA (5) | MAP (20) | GBL | 33000 | 60 | 7.5 | - |
| Synthesis Example 14 | Polyhydroxyamide (a-11) | OBBOC (85) | - | BAHF (100) | - | NA (30) | MPA | 28000 | - | - | 4.5 |
| Synthesis Example 15 | Polyhydroxyamide (a-12) | OBBOC (100) | - | BAHF (85) | - | OAP (30) | MPA | 32000 | - | - | 4.7 |
| Synthesis Example 16 | Polyhydroxyamide (a-13) | OBBOC (85) | - | BAP (100) | - | MAOC (30) | MPA | 33000 | - | - | 4.2 |
| Synthesis Example 18 | Polyimide (a-15) | ODPA (100) | - | DAP-B (85) | SiDA (5) | MAP (20) | MPA | 26000 | - | 97 | 4.5 |
| Synthesis Example 19 | Polyamic acid ester (a-16) | ODPA (100) | - | HC (85) | SiDA (5) | MAP (20) | MPA | 34000 | 72 | 6.1 | 4.1 |
| Synthesis Example 20 | Polyamic acid ester (a-17) | ODPA (100) | - | HC (85) | SiDA (5) | MAP (20) | MPA | 31000 | 73 | 5.9 | 1.0 |

[Example 1]

Under yellow light, 4.20 g of the polyimide resin (a-1) as the component (A), 0.840 g of HMOM-TPHAP (manufactured by Honshu Chemical Industry Co., Ltd.; a compound represented by the following formula (15)) as the component (I) being a crosslinking agent, and 0.004 g of BYK-302 (manufactured by BYK Japan KK) as the surfactant (K) were added to 28.6 g of a mixed solvent in which a mass ratio of PGME and ethyl lactate as the component (D) and dihydrolevoglucosenone (product name: Cyrene, manufactured by Sigma-Aldrich Co. LLC) as the component (B) was 45 : 45 : 10, and the resulting mixture was stirred for 30 minutes to be dissolved, affording a uniform solution having a solid content of 15.0 mass%.

[Chemical Formula 18]

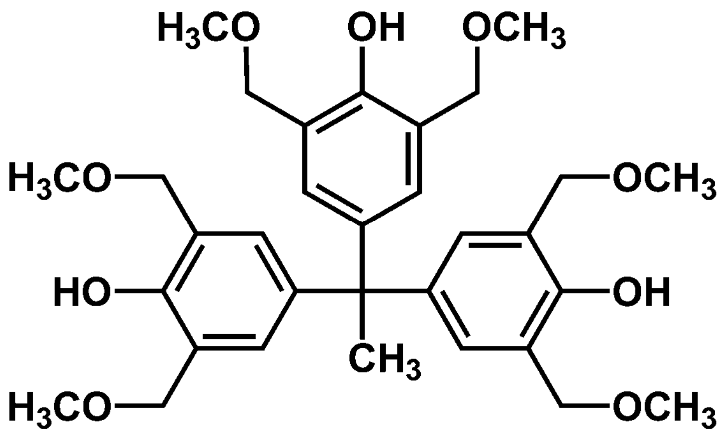

Thereafter, the resulting solution was filtered through a 0.45-μmφ filter, affording a resin composition 1 shown in Table 2-1. Subsequently, using the obtained resin composition 1, various measurements and evaluations were conducted by the respective methods (7) to (10) described above, and their results are shown in Table 3-1.

[Examples 2 to 17 and 25 to 29 and Comparative Examples 1 to 3]

Resin compositions 2 to 17, 25 to 27, and 30 to 34 and cured films were prepared in the same manner as in Example 1 except that the resin compositions were prepared with the compositions shown in Tables 2-1 to 2-3. In Example 3, levoglucosenone manufactured by Tokyo Chemical Industry Co., Ltd. was used. These evaluation results are collectively shown in Tables 3-1 to 3-2.

[Example 18]

Under yellow light, 4.20 g of the polyimide resin (A-1) as the component (A), 0.504 g of QD-a and 0.504 g of QD-b, which were photoacid generators, as the component (E) being a photosensitive agent, 0.420 g of BPAF as the component (J) being a dissolution accelerator, 0.840 g of HMOM-TPHAP (manufactured by Honshu Chemical Industry Co., Ltd.; a compound represented by the formula (15)) as the crosslinking agent (I), and 0.005 g of BYK-333 (manufactured by BYK Japan KK) as the component (K) being a surfactant were added to 29.5 g of a mixed solvent in which a mass ratio of PGME and ethyl lactate as the component (D) and dihydrolevoglucosenone (product name: Cyrene, manufactured by Sigma-Aldrich Co. LLC) as the component (B) was 35 : 35 : 30, and the resulting mixture was stirred for 30 minutes to be dissolved, affording a uniform solution having a solid content of 18.0 mass%.

Thereafter, the resulting solution was filtered through a 0.45-μmφ filter, affording a positive photosensitive resin composition 18 shown in Table 2-2. Subsequently, using the obtained positive photosensitive resin composition 18, various measurements and evaluations were conducted by the respective methods (6) to (10) described above, and their results are shown in Table 3-1.

Next, by the following method, a patterned cured film-formed substrate including a cured film obtained by curing the positive photosensitive composition 18, and an organic EL display device for evaluating light emission reliability including the patterned cured film as a pixel defining layer were prepared.

The process of producing an organic EL display device including a step of forming a pixel defining layer is illustrated in Fig. 2.

A thin film (volume ratio: 10 : 1) of a silver/copper alloy having a thickness of 10 nm was formed on the entire

surface of a non-alkali glass substrate (3) (square of 46 mm in width × 46 mm in length) by sputtering, and then etched to form a patterned metal reflection layer (4). Subsequently, an ITO transparent conductive coating having a thickness of 10 nm was formed on the entire surface by sputtering, and etched to form a second electrode (5) having the same pattern and an auxiliary electrode (6) as an extracting electrode, and then ultrasonically washed with "Semico Clean" (registered trademark) 56 (manufactured by Furuuchi Chemical Corporation) for 10 minutes and washed with deionized water, affording an electrode-formed substrate.

The positive photosensitive composition 18 was applied to the surface of the electrode-formed substrate using a spin coater with the rotation speed adjusted such that a finally obtained pixel defining layer had a thickness of 2.0 μm, and thus a coating film was obtained. Subsequently, the coating film was prebaked at 120°C for 120 seconds under atmospheric pressure using a hot plate (HPD-3000BZN manufactured by AS ONE Corporation), affording a prebaked film.

A positive exposure mask was set on the coating film such that the vertical/horizontal edge portions in the patterned light shielding portion of the positive exposure mask in which openings (rectangles of 30 μm in width/165 μm in length) were arranged at an inter-opening pitch of 50 μm were parallel to the vertical/horizontal edge portions of the non-alkali glass substrate (3), respectively, and the prebaked film was pattern-irradiated with exposure light of a mixed line of a j ray (313 nm), an i ray (wavelength: 365 nm), an h ray (wavelength: 405 nm) and a g ray (wavelength: 436 nm) of an ultra-high pressure mercury lamp at a minimum required exposure energy through the positive exposure mask using a manually operated exposure machine MA-1200 (manufactured by Japan Science Engineering Co., Ltd.), whereby an exposed film was obtained. Subsequently, development and rinsing were conducted, affording a developed film. As the positive exposure mask, a mask with a patterned light shielding portion made of chromium formed on a surface of a soda glass substrate was used.

Further, the developed film was subjected to a heat treatment (curing) to form a cured film, thereby yielding a patterned cured film-formed substrate having an opening ratio of 18%, which included a 2.0 μm-thick patterned cured film (7) in which openings (rectangles of 30 μm in width × 165 μm in length) were arranged at an inter-opening pitch of 50 μm in an area of 16 mm in length × 16 mm in width at the central portion of the electrode-formed substrate. The curing was conducted under the condition in which the temperature was raised to 250°C at 5°C/min at an oxygen concentration of 20 ppm or less and a heat treatment was conducted at 250°C for 1 hour using a high-temperature inert gas oven INH-9CD-S (manufactured by Koyo Thermo Systems Co., Ltd.). In the organic EL display device obtained after the process described later, the opening as referred to here is a portion that finally becomes a light-emitting pixel portion, and the patterned cured film is a portion corresponding to a pixel defining layer.

Next, an organic EL display device was produced using the patterned cured film-formed substrate. To form the organic EL layer (8) including a light-emitting layer by a vacuum deposition method, the patterned cured film-formed substrate was rotated with respect to a deposition source under the vapor deposition condition specified by a degree of vacuum of $1 \times 10^{-3}$ Pa or less, and first, a film of a compound HT-1 was formed in a thickness of 10 nm as a hole injection layer, and a film of a compound HT-2 was formed in a thickness of 50 nm as a hole transport layer. Next, a compound GH-1 as a host material and a compound GD-1 as a dopant material were deposited on the light-emitting layer in a thickness of 40 nm. Thereafter, a compound (ET-1) and a compound (LiQ) were stacked as electron transporting materials with a volume ratio of 1 : 1 in a thickness of 40 nm.

Next, the compound (LiQ) was deposited in a thickness of 2 nm, and then a silver/magnesium alloy (volume ratio: 10 : 1) was deposited in a thickness of 10 nm to form a first electrode (9).

The chemical structures of the compound groups (HT-1, HT-2, GH-1, GD-1, ET-1, LiQ) used for forming the organic EL layer are shown below.

[Chemical Formula 19]

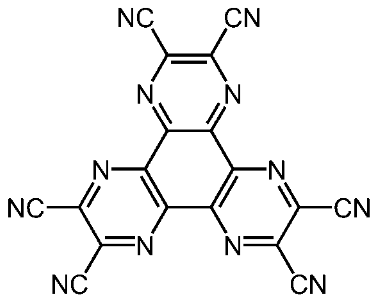

HT-1

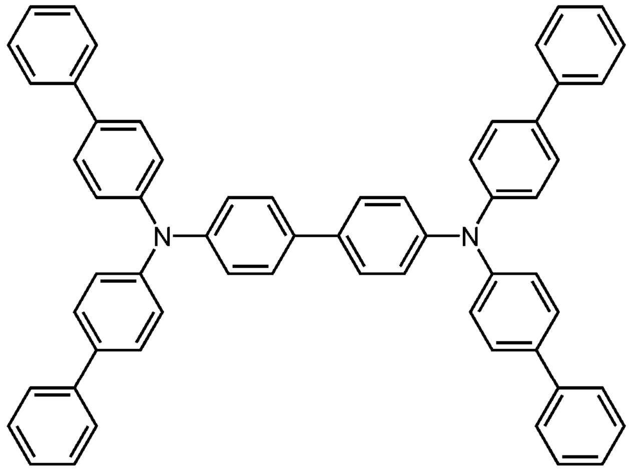

HT-2

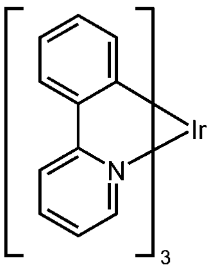

GD-1

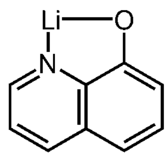

LiQ

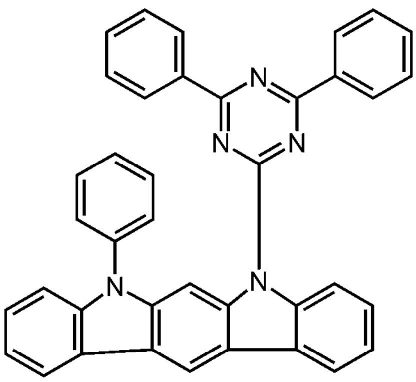

GH-1

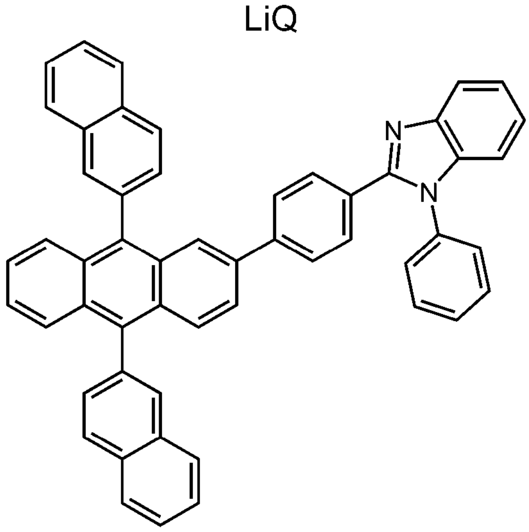

ET-1

It is to be noted that the film thickness as referred to herein is a value displayed on a crystal oscillation-type film thickness monitor.

Thereafter, under a low-humidity nitrogen atmosphere, sealing was conducted by bonding a cap-shaped glass plate with an epoxy resin-based adhesive, yielding an organic EL display device. The results of evaluating the light emission reliability of the organic EL display device by the method described in the above (11) are also shown in Table 3-1.

[Examples 19 to 21 and 30 to 35 and Comparative Example 4]

Positive photosensitive resin compositions 19 to 21, 28, and 35 to 40, cured films, and organic EL display devices were produced in the same manner as in Example 18 except that the positive photosensitive compositions were prepared

with the compositions shown in Tables 2-2 to 2-3. These evaluation results are collectively shown in Tables 3-1 to 3-2.

[Example 22]

Under yellow light, 4.20 g of the polyimide resin (A-1) as the component (A), 0.204 g of IN-a being a photo initiator, as the component (E) being a photosensitive agent, 1.680 g of 4G as the component (F) being a radical polymerizable compound, 0.084 g of MW-390 (manufactured by Sanwa Chemical Co., Ltd.) as the component (I) being a crosslinking agent, 0.060 g of KBM-303 (manufactured by Shin-Etsu Chemical Co., Ltd.) as other additives, and 0.005 g of BYK-302 (manufactured by BYK Japan KK) as the component (K) being a surfactant, were added to 28.4 g of a mixed solvent in which a mass ratio of PGME and ethyl lactate as the component (D) and dihydrolevoglucosenone (product name: Cyrene, manufactured by Sigma-Aldrich Co. LLC) as the component (B) was 35 : 35 : 30, and the resulting mixture was stirred for 30 minutes to be dissolved, affording a uniform solution having a solid content of 18.0 mass%.

Thereafter, the resulting solution was filtered through a 0.45-μmφ filter, affording a negative photosensitive resin composition 22 shown in Table 2-2. Subsequently, using the obtained negative photosensitive resin composition 22, various measurements and evaluations were conducted by the respective methods (6) to (10) described above, and their results are shown in Table 3-1.

Subsequently, a cured film and an organic EL display device were produced in the same manner as in Example 18 except for using the negative photosensitive resin composition 22 and using a negative exposure mask. The results of evaluation conducted by the method described in the above (11) are also shown in Table 3-1.

[Examples 23 and 24 and Comparative Example 5]

Negative photosensitive resin compositions 23,24, and 29, cured films, and organic EL display devices were produced in the same manner as in Example 22 except that the negative photosensitive resin compositions were prepared with the compositions shown in Tables 2-2 to 2-3. These evaluation results are collectively shown in Tables 3-1 to 3-2.

[Table 2-1-1]

| | Resin composition | Composition (parts by mass) | | | | | | |
|---|---|---|---|---|---|---|---|---|
| | | Component (A) | Component (E) | Component (F) | Component (H) | Component (I) | Component (J) | Component (K) |
| Example 1 | 1 | a-1 (100) | - | - | - | i-1 (20) | j-1 (0.1) | - |
| Example 2 | 2 | a-1 (100) | - | - | - | i-1 (20) | j-1 (0.1) | - |
| Example 3 | 3 | a-1 (100) | - | - | - | i-1 (20) | j-1 (0.1) | - |
| Example 4 | 4 | a-1 (100) | - | - | - | i-1 (20) | j-1 (0.1) | - |
| Example 5 | 5 | a-1 (100) | - | - | - | i-1 (20) | j-1 (0.1) | - |
| Example 6 | 6 | a-2 (100) | - | - | - | i-1 (20) | j-1 (0.1) | - |
| Example 7 | 7 | a-3 (100) | - | - | - | i-1 (20) | j-1 (0.1) | - |
| Example 8 | 8 | a-4 (100) | - | - | - | i-1 (20) | j-1 (0.1) | - |
| Example 9 | 9 | a-5 (100) | - | - | - | i-1 (20) | j-1 (0.1) | - |
| Example 10 | 10 | a-6 (100) | - | - | - | i-1 (20) | j-1 (0.1) | - |
| Example 11 | 11 | a-7 (100) | - | - | - | i-1 (20) | j-1 (0.1) | - |
| Example 12 | 12 | a-8 (100) | - | - | - | i-1 (20) | j-1 (0.1) | - |
| Example 13 | 13 | a-9 (100) | - | - | - | i-1 (20) | j-1 (0.1) | - |
| Example 14 | 14 | a-10 (100) | - | - | - | i-1 (20) | j-1 (0.1) | - |
| Example 15 | 15 | a-11 (100) | - | - | - | i-1 (20) | j-1 (0.1) | - |
| Example 16 | 16 | a-12 (100) | - | - | - | i-1 (20) | j-1 (0.1) | - |
| Example 17 | 17 | a-13 (100) | - | - | - | i-1 (20) | j-1 (0.1) | - |

[Table 2-1-2]

| | Resin composition | Composition (parts by mass) | | | | | |
|---|---|---|---|---|---|---|---|
| | | Component (B) | Component (C) | Mass ratio of component (B) to component (C) (X/Y) | Component (D) | Mass ratio of component (B) to component (D) (X/Z) | Component (G) |
| Example 1 | 1 | b-1 (68) | c-1 (4.2) | 16 | d-1 (306)<br>d-2 (306) | 0.11 | - |
| Example 2 | 2 | b-1 (204) | c-1 (4.2) | 49 | d-1 (238)<br>d-2 (238) | 0.43 | - |
| Example 3 | 3 | b-2 (204) | c-1 (4.2) | 49 | d-1 (238)<br>d-2 (238) | 0.43 | - |
| Example 4 | 4 | b-1 (667) | c-1 (4.2) | 159 | d-1 (13.6) | 49.0 | - |
| Example 5 | 5 | b-1 (681) | c-1 (4.2) | 162 | - | Not calculable | - |
| Example 6 | 6 | b-1 (204) | c-1 (4.7) | 43 | d-1 (238)<br>d-2 (238) | 0.43 | - |
| Example 7 | 7 | b-1 (204) | c-1 (4.2) | 49 | d-1 (238)<br>d-2 (238) | 0.43 | - |
| Example 8 | 8 | b-1 (204) | c-1 (1.1) | 185 | d-1 (238)<br>d-2 (238) | 0.43 | - |
| Example 9 | 9 | b-1 (204) | c-1 (4.8) | 43 | d-1 (238)<br>d-2 (238) | 0.43 | - |
| Example 10 | 10 | b-1 (204) | c-2 (5.2) | 39 | d-1 (238)<br>d-2 (238) | 0.43 | - |
| Example 11 | 11 | b-1 (204) | c-3 (4.7) | 43 | d-1 (238)<br>d-2 (238) | 0.43 | - |
| Example 12 | 12 | b-1 (204) | c-1 (4.3) | 47 | d-1 (238)<br>d-2 (238) | 0.43 | - |
| Example 13 | 13 | b-1 (204) | - | Not calculable | d-1 (238)<br>d-2 (238) | 0.43 | - |
| Example 14 | 14 | b-1 (204) | - | Not calculable | d-1 (238)<br>d-2 (238) | 0.43 | - |
| Example 15 | 15 | b-1 (204) | c-1 (4.5) | 45 | d-1 (238)<br>d-2 (238) | 0.43 | - |
| Example 16 | 16 | b-1 (204) | c-1 (4.7) | 43 | d-1 (238)<br>d-2 (238) | 0.43 | - |
| Example 17 | 17 | b-1 (204) | c-1 (4.2) | 49 | d-1 (238)<br>d-2 (238) | 0.43 | - |

[Table 2-2-1]

| | Resin composition | Composition (parts by mass) | | | | | | |
|---|---|---|---|---|---|---|---|---|
| | | Component (A) | Component (E) | Component (F) | Component (H) | Component (I) | Component (J) | Component (K) |
| Example 18 | 18 | a-1 (100) | e-1 (12)<br>e-2 (12) | - | h-1 (10) | i-1 (20) | j-1 (0.1) | - |
| Example 19 | 19 | a-3 (100) | e-1 (12)<br>e-2 (12) | - | h-1 (10) h-1 (10) | i-1 (20) | j-1 (0.1) | - |
| Example 20 | 20 | a-5 (100) | e-1 (12)<br>e-2 (12) | - | | i-1 (20) | j-1 (0.1) | - |
| Example 21 | 21 | a-12 (100) | e-1 (12)<br>e-2 (12) | - | h-1 (10) | i-1 (20) | j-1 (0.1) | - |
| Example 22 | 22 | a-5 (100) | e-3 (4.9) | f-1 (40) | - | i-2 (2.0) | j-1 (0.1) | k-1 (1.4) |
| Example 23 | 23 | a-5 (100) | e-4 (4.9) | f-1 (40) | - | i-2 (2.0) | j-1 (0.1) | k-1 (1.4) |
| Example 24 | 24 | a-13 (100) | e-3 (4.9) | f-1 (40) | - | i-2 (2.0) | j-1 (0.1) | k-1 (1.4) |
| Example 25 | 30 | a-1 (100) | - | - | - | i-1 (20) | j-1 (0.1) | - |
| Example 26 | 31 | a-4 (100) | - | - | - | i-1 (20) | j-1 (0.1) | - |
| Example 27 | 32 | a-15 (100) | - | - | - | i-1 (20) | j-1 (0.1) | - |
| Example 28 | 33 | a-16 (100) | - | - | - | i-1 (20) | j-1 (0.1) | - |
| Example 29 | 34 | a-17 (100) | - | - | - | i-1 (20) | j-1 (0.1) | - |
| Example 30 | 35 | a-16 (100) | e-1 (12)<br>e-2 (12) | - | h-1 (10) | i-1 (20) | j-1 (0.1) | - |
| Example 31 | 36 | a-16 (100) | e-1 (12)<br>e-2 (12) | - | h-1 (10) | i-1 (20) | j-1 (0.1) | - |
| Example 32 | 37 | a-16 (100) | e-1 (12)<br>e-2 (12) | - | h-1 (10) | i-1 (20) | j-1 (0.1) | - |
| Example 33 | 38 | a-17 (100) | e-1 (12)<br>e-2 (12) | - | h-1 (10) | i-1 (20) | j-1 (0.1) | - |
| Example 34 | 39 | a-17 (100) | e-1 (12)<br>e-2 (12) | - | h-1 (10) | i-1 (20) | j-1 (0.1) | - |

(continued)

| | Resin composition | Composition (parts by mass) | | | | | | |
|---|---|---|---|---|---|---|---|---|
| | | Component (A) | Component (E) | Component (F) | Component (H) | Component (I) | Component (J) | Component (K) |
| Example 35 | 40 | a-17 (100) | e-1 (12)<br>e-2 (12) | - | h-1 (10) | i-1 (20) | j-1 (0.1) | - |

[Table 2-2-2]

| | Resin composition | Composition (parts by mass) | | | | | |
|---|---|---|---|---|---|---|---|
| | | Component (B) | Component (C) | Mass ratio of component (B) to component (C) (X/Y) | Component (D) | Mass ratio of component (B) to component (D) (X/Z) | Component (G) |
| Example 18 | 18 | b-1 (211) | c-1 (4.2) | 50 | d-1 (246)<br>d-2 (246) | 0.43 | - |
| Example 19 | 19 | b-1 (211) | c-1 (4.2) | 50 | d-1 (246)<br>d-2 (246) | 0.43 | - |
| Example 20 | 20 | b-1 (211) | c-1 (4.8) | 44 | d-1 (246)<br>d-2 (246) | 0.43 | - |
| Example 21 | 21 | b-1 (211) | c-1 (4.7) | 45 | d-1 (246)<br>d-2 (246) | 0.43 | - |
| Example 22 | 22 | b-1 (203) | c-1 (4.2) | 48 | d-1 (237)<br>d-2 (237) | 0.43 | - |
| Example 23 | 23 | b-1 (203) | c-1 (4.2) | 48 | d-1 (237)<br>d-2 (237) | 0.43 | - |
| Example 24 | 24 | b-1 (203) | c-1 (4.7) | 43 | d-1 (237)<br>d-2 (237) | 0.43 | - |
| Example 25 | 30 | b-1 (10) | c-1 (4.2) | 2 | d-1 (335)<br>d-2 (335) | 0.01 | - |
| Example 26 | 31 | b-1 (320) | c-1 (1.1) | 291 | d-1 (185)<br>d-2 (185) | 0.86 | - |
| Example 27 | 32 | b-1 (204) | c-1 (4.5) | 45 | d-1 (238)<br>d-2 (238) | 0.43 | - |
| Example 28 | 33 | b-1 (204) | c-1 (4.1) | 50 | d-1 (238)<br>d-2 (238) | 0.43 | - |
| Example 29 | 34 | b-1 (204) | c-1 (1.0) | 204 | d-1 (238)<br>d-2 (238) | 0.43 | - |
| Example 30 | 35 | b-1 (211) | c-1 (4.2) | 50 | d-1 (246)<br>d-2 (246) | 0.43 | - |
| Example 31 | 36 | b-1 (81) | c-1 (4.2) | 19 | d-1 (311)<br>d-2 (311) | 0.13 | - |
| Example 32 | 37 | b-1 (10) | c-1 (4.2) | 2 | d-1 (335)<br>d-2 (335) | 0.01 | - |
| Example 33 | 38 | b-1 (290) | c-1 (1.0) | 290 | d-1 (200)<br>d-2 (200) | 0.73 | - |
| Example 34 | 39 | b-1 (340) | c-1 (1.0) | 340 | d-1 (175)<br>d-2 (175) | 0.97 | - |
| Example 35 | 40 | b-1 (420) | c-1 (1.0) | 420 | d-1 (135)<br>d-2 (135) | 1.56 | - |

[Table 2-3-1]

| | Resin composition | Composition (parts by mass) | | | | | | |
|---|---|---|---|---|---|---|---|---|
| | | Component (A) | Component (E) | Component (F) | Component (H) | Component (I) | Component (J) | Component (K) |
| Comparative Example 1 | 25 | a-1 (100) | - | - | - | i-1 (20) | j-1 (0.1) | - |
| Comparative Example 2 | 26 | a-1 (100) | - | - | - | i-1 (20) | j-1 (0.1) | - |
| Comparative Example 3 | 27 | a-14 (100) | - | - | - | i-1 (20) | j-1 (0.1) | - |
| Comparative Example 4 | 28 | a-3 (100) | e-1 (12)<br>e-2 (12) | - | h-1 (10) | i-1 (20) | j-1 (0.1) | - |
| Comparative Example 5 | 29 | a-5 (100) | e-3 (4.9) | f-1 (40) | - | i-2 (2.0) | j-1 (0.1) | k-1 (1.4) |

[Table 2-3-2]

| | Resin composition | Composition (parts by mass) | | | | | |
|---|---|---|---|---|---|---|---|
| | | Component (B) | Component (C) | Mass ratio of component (B) to component (C) (X/Y) | Component (D) | Mass ratio of component (B) to component (D) (X/Z) | Component (G) |
| Comparative Example 1 | 25 | - | c-1 (4.2) | 0 | d-1 (238)<br>d-2 (238) | 0.00 | g-1 (204) |
| Comparative Example 2 | 26 | - | c-1 (4.2) | 0 | d-1 (238)<br>d-2 (238) | 0.00 | g-2 (204) |
| Comparative Example 3 | 27 | b-1 (204) | - | Not calcul-able | d-1 (238)<br>d-2 (238) | 0.43 | - |
| Comparative Example 4 | 28 | - | c-1 (4.2) | 0 | d-1 (246)<br>d-2 (246) | 0.00 | g-1 (211) |
| Comparative Example 5 | 29 | - | c-1 (4.8) | 0 | d-1 (237)<br>d-2 (237) | 0.00 | g-1 (203) |

The components shown in Table 2-1 to Table 2-3 are as follows.

Component (A)

(a-1), (a-2), (a-15): The polyimide resins described above.
(a-3) to (a-7), (a-9), (a-10), (a-16), (a-17): Polyamic acid ester resin described above
(a-8): Polyamic acid described above
(a-11) to (a-13): The polyhydroxyamides described above.
(a-14): The phenol resin described above.

Component (B)

(b-1): Dihydrolevoglucosenone (product name: Cyrene, manufactured by Sigma-Aldrich Co. LLC)
(b-2): Levoglucosenone (manufactured by Tokyo Chemical Industry Co., Ltd.)

Component (C)

(c-1): MPA (Compound represented by formula (1))
(c-2): DMIB (Compound represented by formula (2))
(c-3): DMPA (Compound represented by formula (2))

Component (D)

(d-1): PGME (Compound having hydroxyl group and having boiling point of 120°C at atmospheric pressure)
(d-2): Ethyl lactate (Compound having hydroxyl group and having boiling point of 154°C at atmospheric pressure)

Component (E)

(e-1): QD-a (Compound described in Synthesis Example 1)
(e-2): QD-b (Compound described in Synthesis Example 2)
(e-3): NCI-930 (manufactured by ADEKA Corporation)
(e-4): Bis($\eta^5$-2,4-cyclopentadien-1-yl)-bis[2,6-difluoro-3-(1H-pyrrol-1-yl)phenyl]titanium(IV) (manufactured by Tokyo Chemical Industry Co., Ltd.)

Component (F)
(f-1): NK Ester 4G (manufactured by Shin Nakamura Chemical Co., Ltd.)
Component (G)

(g-1): GBL (Compound having no hydroxyl group and having boiling point of 204°C at atmospheric pressure)
(g-2): CHN (Compound having no hydroxyl group and having a boiling point of 156°C at atmospheric pressure)

Component (H)
(h-1): BPAF (manufactured by Tokyo Chemical Industry Co., Ltd.)
Component (I)

(i-1): HMOM-TPHAP (manufactured by Honshu Chemical Industry Co., Ltd.)
(i-2): MW-390 (manufactured by Sanwa Chemical Co., Ltd.)

Component (J)
(j-1): BYK-302 (manufactured by BYK Japan KK)
Component (K)
(k-1): KBM-303 (manufactured by Shin-Etsu Chemical Co., Ltd.)

[Table 3-1]

| | Resin composition | Photosensitive characteristics/ cured film characteristics | | | | | | Evaluation of light emission reliability of organic EL display device | | |
|---|---|---|---|---|---|---|---|---|---|---|
| | | Flatness | Chemical resistance | Breaking elongation | Adhesion | | Sensitivity | After 1 hour | After 100 hours | After 500 hours |
| | | | | | 400 hours | 800 hours | | | | |
| Example 1 | 1 | A | A | A | A | B | - | - | - | - |
| Example 2 | 2 | A | A | A | A | B | - | - | - | - |
| Example 3 | 3 | B | B | B | B | C | - | - | - | - |
| Example 4 | 4 | A | A | A | B | C | - | - | - | - |
| Example 5 | 5 | B | A | A | B | C | - | - | - | - |
| Example 6 | 6 | A | A | A | A | B | - | - | - | - |
| Example 7 | 7 | A | A | A | A | B | - | - | - | - |
| Example 8 | 8 | A | A | A | A | B | - | - | - | - |
| Example 9 | 9 | A | A | AA | A | B | - | - | - | - |
| Example 10 | 10 | A | A | A | A | B | - | - | - | - |
| Example 11 | 11 | A | A | A | A | B | - | - | - | - |

(continued)

| | Resin composition | Photosensitive characteristics/ cured film characteristics | | | | | | Evaluation of light emission reliability of organic EL display device | | |
|---|---|---|---|---|---|---|---|---|---|---|
| | | Flatness | Chemical resistance | Breaking elongation | Adhesion | | Sensitivity | After 1 hour | After 100 hours | After 500 hours |
| | | | | | 400 hours | 800 hours | | | | |
| Example 12 | 12 | A | A | A | A | B | - | - | - | - |
| Example 13 | 13 | A | A | B | B | C | - | - | - | - |
| Example 14 | 14 | A | A | B | B | C | - | - | - | - |
| Example 15 | 15 | A | A | A | A | B | - | - | - | - |
| Example 16 | 16 | A | A | A | A | B | - | - | - | - |
| Example 17 | 17 | A | A | A | A | A | - | - | - | - |
| Example 18 | 18 | A | A | A | A | B | B | A | A | A |
| Example 19 | 19 | A | A | A | A | B | A | A | A | A |
| Example 20 | 20 | A | A | AA | A | B | A | A | A | A |
| Example 21 | 21 | A | A | A | A | B | A | A | B | B |
| Example 22 | 22 | A | A | AA | A | B | A | A | A | A |
| Example 23 | 23 | A | A | AA | A | B | A | A | A | A |
| Example 24 | 24 | A | A | A | A | A | B | A | B | B |

[Table 3-2]

| | Resin composition | Photosensitive characteristics/ cured film characteristics | | | | | | Evaluation of light emission reliability of organic EL display device | | |
|---|---|---|---|---|---|---|---|---|---|---|
| | | Flatness | Chemical resistance | Breaking elongation | Adhesion | | Sensitivity | After 1 hour | After 100 hours | After 500 hours |
| | | | | | 400 hours | 800 hours | | | | |
| Example 25 | 30 | C | B | B | B | C | - | - | - | - |
| Example 26 | 31 | A | A | A | A | B | - | - | - | - |
| Example 27 | 32 | A | A | A | A | A | - | - | - | - |
| Example 28 | 33 | A | A | A | A | A | - | - | - | - |
| Example 29 | 34 | A | A | A | A | A | - | - | - | - |
| Example 30 | 35 | A | A | A | A | A | A | A | A | A |
| Example 31 | 36 | A | A | A | A | A | A | A | A | A |
| Example 32 | 37 | B | A | B | B | B | A | A | B | B |
| Example 33 | 38 | A | A | A | A | A | A | A | A | A |
| Example 34 | 39 | A | A | A | A | A | A | A | A | A |
| Example 35 | 40 | A | A | A | A | A | B | A | A | A |
| Comparative Example 1 | 25 | D | C | C | C | D | - | - | - | - |
| Comparative Example 2 | 26 | D | C | C | C | D | - | - | - | - |
| Comparative Example 3 | 27 | C | D | D | D | D | - | - | - | - |
| Comparative Example 4 | 28 | D | C | C | C | B | B | A | C | D |
| Comparative Example 5 | 29 | D | C | C | C | D | A | A | C | D |

The above results show that the resin compositions of Examples have excellent flatness, breaking elongation, and chemical resistance, and are excellent in adhesion to metal materials. In Comparative Examples 1 and 2, since the component (B) was not contained, the flatness was poor. In Comparative Example 3, since the component (A) was not contained, the breaking elongation, chemical resistance, and the adhesion to metal materials were poor.

## INDUSTRIAL APPLICABILITY

The resin composition of the present invention is suitably used for a bank layer of an organic EL display device, a planarization layer of a TFT substrate for driving an organic EL display device, and an insulating film or a protective film constituting an electronic component. Examples of the electronic component include active components having a semiconductor such as transistors, diodes, integrated circuits (ICs), and memories, as well as passive components such as resistors, capacitors, and inductors.

The cured film of the present invention is suitably used for a bank layer of an organic EL display device, a planarization layer of a TFT substrate for driving an organic EL display device, and an insulating film or a protective film constituting an electronic component. Examples of the electronic component include active components having a semiconductor such as transistors, diodes, integrated circuits (ICs), and memories, as well as passive components such as resistors, capacitors, and inductors.

## DESCRIPTION OF REFERENCE SIGNS

1: Stepped substrate
2: Cured film
3: Non-alkali glass substrate
4: Metal reflection layer
5: Second electrode
6: Auxiliary electrode
7: Patterned cured film
8: Organic EL layer
9: First electrode
10: Baseline

## Claims

1. A resin composition comprising: a component (A) being one or more resins selected from the group consisting of a polyimide resin (A1), a polybenzoxazole resin (A2), and a copolymer resin (A3) of a structural unit of a polyimide resin and a structural unit of a polybenzoxazole resin; and a component (B) being levoglucosenone and/or dihydrolevoglucosenone.

2. The resin composition according to claim 1, further comprising a component (D) being a compound having a hydroxyl group and having a boiling point at atmospheric pressure of 100°C or more and 200°C or less.

3. The resin composition according to claim 2, wherein a ratio X/Z is 0.01 or more and 10 or less where a mass of the component (B) contained in the resin composition is denoted by X and a mass of the component (D) contained in the resin composition is denoted by Z.

4. The resin composition according to claim 1 or 2, further comprising a component (C) being a compound represented by formula (1) and/or a compound represented by formula (2):

[Chemical Formula 1]

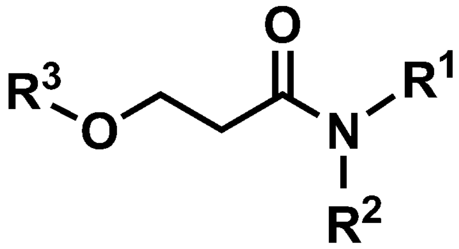

(1)

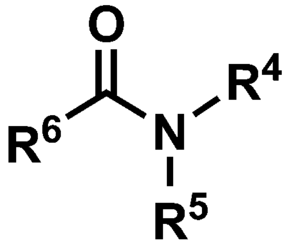

(2)

where in the formula (1), $R^1$, $R^2$ and $R^3$ are each independently an alkyl group having 1 to 6 carbon atoms; in the formula (2), $R^4$ and $R^5$ are each independently an alkyl group having 1 to 6 carbon atoms, and $R^6$ is a hydrogen atom or an alkyl group having 1 to 6 carbon atoms.

5. The resin composition according to claim 4, wherein a ratio X/Y is 1 or more and 1,000 or less where a mass of the component (B) contained in the resin composition is denoted by X and a mass of the component (C) contained in the resin composition is denoted by Y.

6. The resin composition according to claim 1 or 2, further comprising a component (E) being a photosensitive agent.

7. The resin composition according to claim 6, wherein the component (E) includes a component (E1) being a photo initiator and/or a component (E2) being a photoacid generator.

8. The resin composition according to claim 7, wherein the component (E1) includes a component (E1-1) being an oxime ester photoinitiator and/or a component (E1-2) being a titanocene photoinitiator.

9. The resin composition according to claim 8, further comprising a component (F) being a radical polymerizable compound.

10. The resin composition according to claim 1 or 2, wherein the component (A) includes a polyimide resin (A1) and/or a copolymer resin (A3) of a structural unit of a polyimide resin and a structural unit of a polybenzoxazole resin, and the component (A) contains a structural unit represented by formula (3):

[Chemical Formula 2]

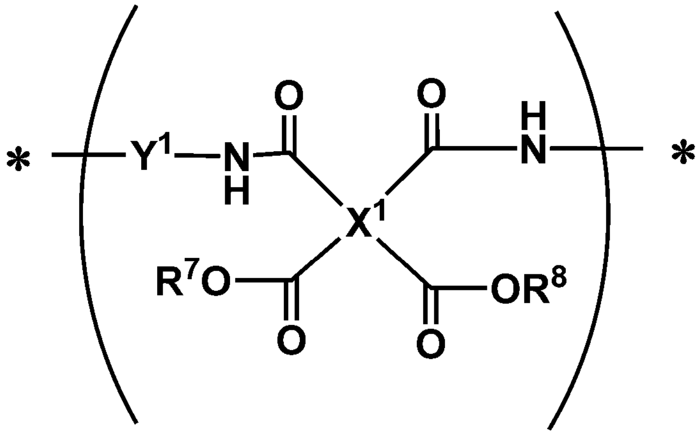

(3)

where in the formula (3), $X^1$ represents a tetravalent organic group having 2 to 40 carbon atoms and having any structure among an aliphatic structure having 2 to 20 carbon atoms, an alicyclic structure having 4 to 20 carbon atoms, and an aromatic structure having 6 to 40 carbon atoms; $Y^1$ represents a divalent organic group having 2 to 40 carbon atoms and having any structure among an aliphatic structure having 2 to 20 carbon atoms, an alicyclic structure having 4 to 20 carbon atoms, and an aromatic structure having 6 to 40 carbon atoms; $R^7$ and $R^8$ each independently represent a hydrogen atom, an alkyl group having 1 to 20 carbon atoms, or a monovalent organic group having an ethylenically unsaturated double bond; each * represents a bonding site.

**11.** The resin composition according to claim 10, wherein $Y^1$ in the formula (3) is a divalent organic group represented by the formula (4) or the formula (5):

[Chemical Formula 3]

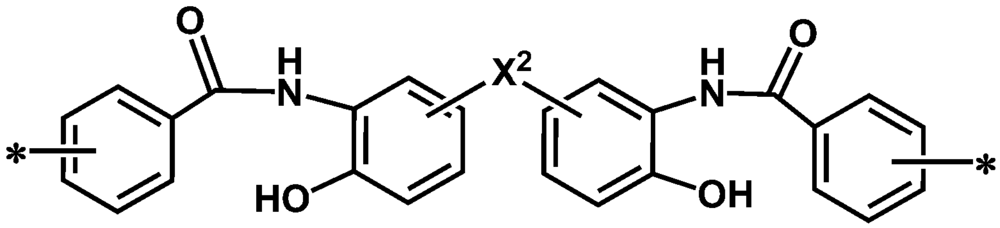

(4)

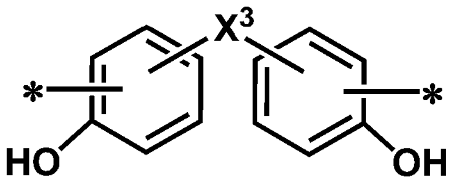

(5)

where in the formulas (4) and (5), $X^2$ and $X^3$ each independently represent a direct bond, $-SO_2-$, -O-, or a divalent organic group having 1 to 20 carbon atoms; each * represents a bonding point bonded to an amide structure, an imide structure, an amic acid ester structure, or an amic acid structure.

**12.** The resin composition according to claim 11, wherein $X^2$ and $X^3$ are each independently a divalent organic group having 1 to 20 carbon atoms and containing no fluorine atom.

**13.** A cured film comprising a cured product of the resin composition according to claim 1 or 2.

**14.** An electronic component comprising the cured film according to claim 13.

**15.** An organic EL display device comprising the cured film according to claim 13.

【Fig. 1】

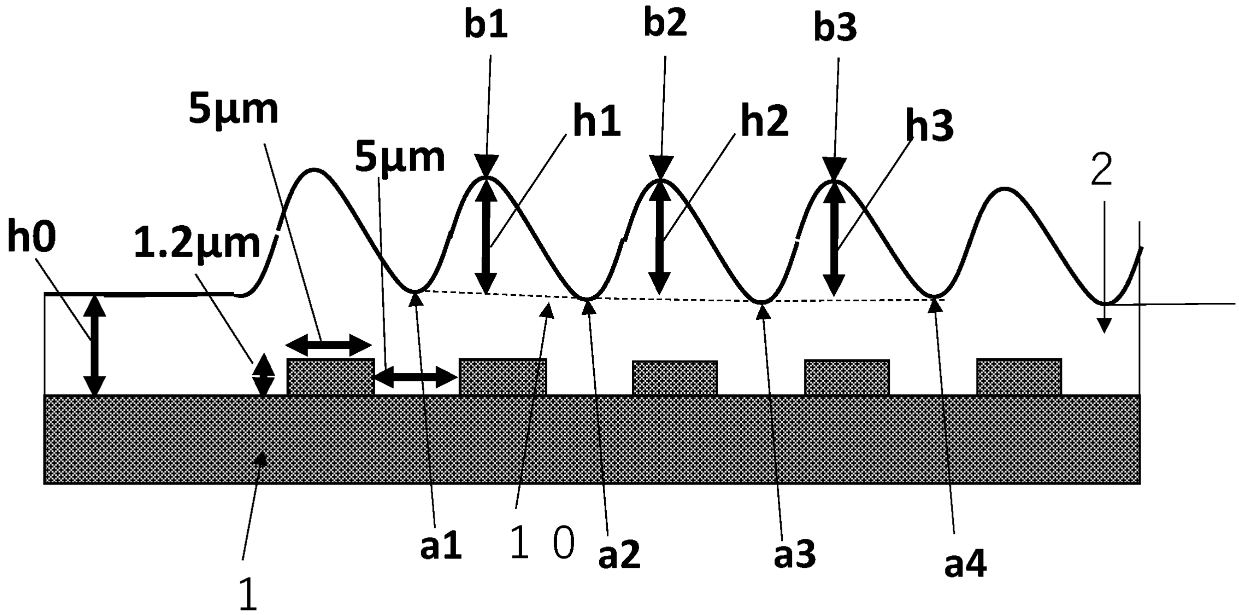


【Fig. 2】

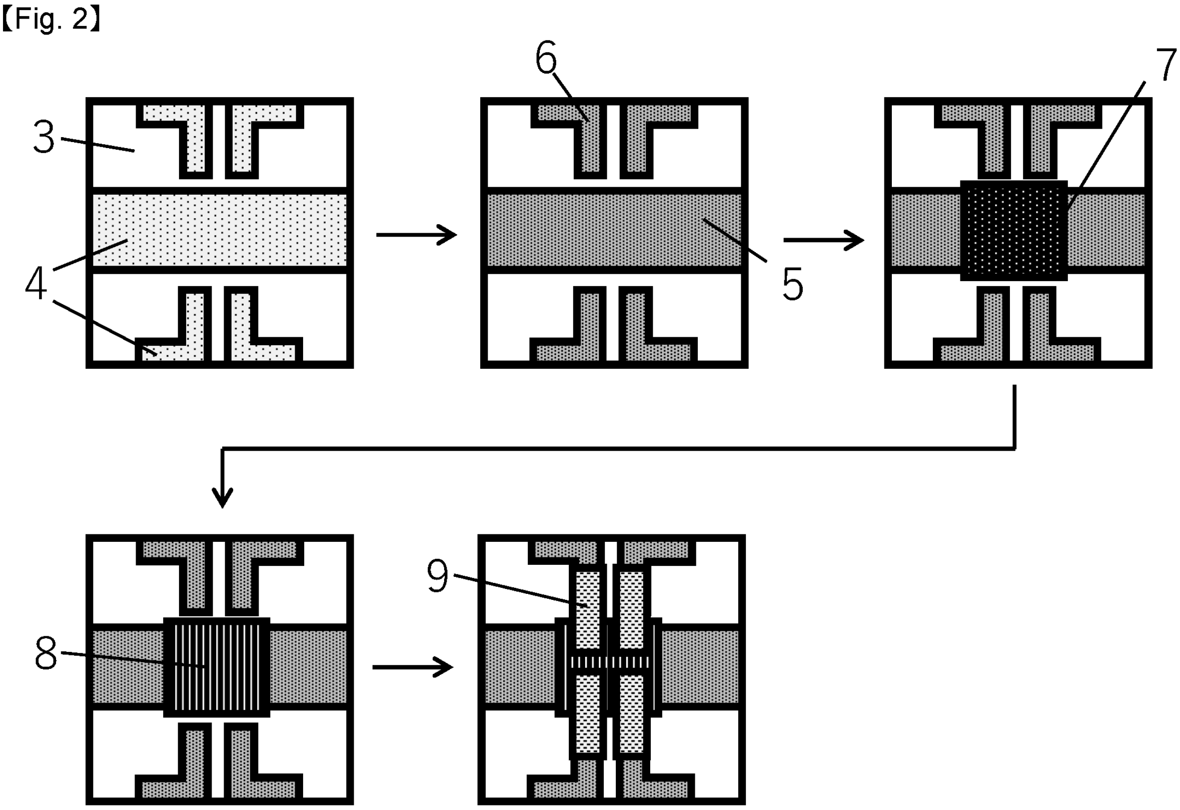

## INTERNATIONAL SEARCH REPORT

International application No. **PCT/JP2024/024716**

### A. CLASSIFICATION OF SUBJECT MATTER

***C08L 79/04***(2006.01)i; ***C08G 73/06***(2006.01)i; ***C08K 5/20***(2006.01)i; ***C08K 5/156***(2006.01)i; ***G03F 7/031***(2006.01)i; ***G03F 7/037***(2006.01)i; ***H10K 59/122***(2023.01)i; ***H10K 85/10***(2023.01)i
FI: C08L79/04; C08K5/156; C08K5/20; C08G73/06; G03F7/031; G03F7/037; H10K85/10; H10K59/122

According to International Patent Classification (IPC) or to both national classification and IPC

### B. FIELDS SEARCHED

Minimum documentation searched (classification system followed by classification symbols)

C08L79/04; C08G73/06; C08K5/20; C08K5/156; G03F7/031; G03F7/037; H10K59/122; H10K85/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | WO 2023/032753 A1 (NISSAN CHEMICAL CORPORATION) 09 March 2023 (2023-03-09) claims, paragraphs [0057], [0059]-[0061], [0079]-[0090], [0096], example 1 | 1-5, 13-14<br>1-15 |
| X<br>A | WO 2019/008382 A1 (WUHAN XINQU CHUANGROU OPTOELECTRONICS TECHNOLOGY CO., LTD.) 10 January 2019 (2019-01-10) claims 1, 3, 9, p. 41, lines 22-37 | 1, 13-14<br>2-12, 15 |
| Y | JP 2021-155467 A (TORAY INDUSTRIES, INC.) 07 October 2021 (2021-10-07) claims, paragraphs [0002], [0006], [0048]-[0053], [0069], [0078]-[0083], [0085]-[0091], [0106] | 1-15 |
| A | WO 2020/009911 A1 (NANOTEK INSTRUMENTS, INC.) 09 January 2020 (2020-01-09) entire text, all drawings | 1-15 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 September 2024** | **08 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/024716**

**C. DOCUMENTS CONSIDERED TO BE RELEVANT**

| Category* | Citation of document, with indication, where appropriate, of the relevant passages | Relevant to claim No. |
|---|---|---|
| A | WO 2022/224838 A1 (FUJIFILM CORPORATION) 27 October 2022 (2022-10-27) entire text | 1-15 |

Form PCT/ISA/210 (second sheet) (July 2022)

**INTERNATIONAL SEARCH REPORT**
**Information on patent family members**

International application No.
**PCT/JP2024/024716**

| Patent document cited in search report | Publication date (day/month/year) | Patent family member(s) | Publication date (day/month/year) |
|---|---|---|---|
| WO 2023/032753 A1 | 09 March 2023 | CN 117957488 A | |
| WO 2019/008382 A1 | 10 January 2019 | (Family: none) | |
| JP 2021-155467 A | 07 October 2021 | (Family: none) | |
| WO 2020/009911 A1 | 09 January 2020 | US 2020/0002505 A1<br>whole document | |
| WO 2022/224838 A1 | 27 October 2022 | CN 117203265 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017188153 A
- JP 2022034533 A
- WO 2019087985 A
- WO 2019194286 A
- WO 2016052268 A
- WO 2019167461 A
- WO 2019065351 A
- WO 2012141165 A